Europäisches Patentamt

European Patent Office

Office européen des brevets

(19)

(11) **EP 1 242 843 B1**

(12) **EUROPÄISCHE PATENTSCHRIFT**

(45) Veröffentlichungstag und Bekanntmachung des Hinweises auf die Patenterteilung:
**22.03.2006 Patentblatt 2006/12**

(21) Anmeldenummer: **00985239.3**

(22) Anmeldetag: **22.12.2000**

(51) Int Cl.:
**G02B 13/14** *(2006.01)*          **G02B 13/18** *(2006.01)*
**G03F 7/20** *(2006.01)*

(86) Internationale Anmeldenummer:
**PCT/EP2000/013148**

(87) Internationale Veröffentlichungsnummer:
**WO 2001/050171 (12.07.2001 Gazette 2001/28)**

(54) **PROJEKTIONSOBJEKTIV MIT BENACHBART ANGEORDNETEN ASPHÄRISCHEN LINSENOBERFLÄCHEN**

PROJECTION LENS COMPRISING ADJACENT ASPHERIC LENS SURFACES

OBJECTIF DE PROJECTION POURVU DE SURFACES DE LENTILLES ASPHERIQUES DISPOSEES L'UNE A COTE DE L'AUTRE

(84) Benannte Vertragsstaaten:
**DE GB NL**

(30) Priorität: **29.12.1999 US 173523 P**
**22.01.2000 DE 10002626**
**04.05.2000 DE 10021739**

(43) Veröffentlichungstag der Anmeldung:
**25.09.2002 Patentblatt 2002/39**

(73) Patentinhaber: **Carl Zeiss SMT AG**
**73446 Oberkochen (DE)**

(72) Erfinder:
• **SHAFER, David, R.**
**Fairfield, CT 06430 (US)**
• **SCHUSTER, Karl-Heinz**
**89551 Königsbronn (DE)**
• **BEIERL, Helmut**
**89522 Heidenheim (DE)**

(74) Vertreter: **Müller-Rissmann, Werner Albrecht et al**
**Carl Zeiss,**
**Patentabteilung**
**73446 Oberkochen (DE)**

(56) Entgegenhaltungen:
**EP-A- 0 332 201          EP-A- 0 816 892**
**EP-A- 0 851 304          EP-A- 1 061 396**
**EP-A- 1 069 448          EP-A- 1 079 253**
**DE-A- 19 818 444          US-A- 4 757 354**
**US-A- 4 861 148          US-A- 5 724 121**
**US-A- 5 835 285          US-A- 5 990 926**

• **PATENT ABSTRACTS OF JAPAN vol. 1999, no. 13, 30. November 1999 (1999-11-30) -& JP 11 231219 A (RICOH OPT IND CO LTD), 27. August 1999 (1999-08-27)**
• **PATENT ABSTRACTS OF JAPAN vol. 1999, no. 03, 31. März 1999 (1999-03-31) -& JP 10 325922 A (NIKON CORP), 8. Dezember 1998 (1998-12-08)**

EP 1 242 843 B1

**Beschreibung**

Die Erfindung betrifft ein Projektionsobjektiv gemäß dem Oberbegriff des Patentanspruchs 1.

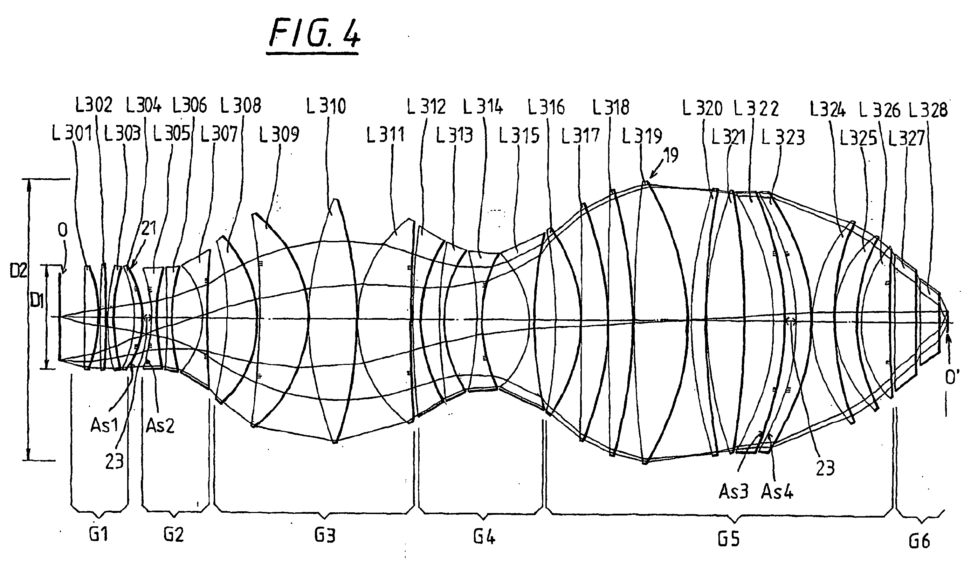

Aus der WO 99/52004 (entspricht EP 1 079 253 A1) sind katadioptische Projektionsobjektive bekannt, die eine Vielzahl von asphärischen Linsenoberflächen umfassen. So weist beispielsweise das in Figur 4 dargestellte Projektionsobjektiv bei 15 Linsen 12 asphärische Linsenoberflächen auf. Da die Herstellungskosten von asphärischen Linsenoberflächen mit der in der Mikrolithographie geforderten Genauigkeit sehr hoch sind, dürften diese Objektive aufgrund der vielen erforderlichen asphärischen Linsenoberflächen für den Markt weniger interessant sein. WO 99/52004 offenbart den Oberbegriff von Anspruch 1.

Aus der EP 332 201 B1 ist ein optisches Projektionssystem insbesondere für die Photolithographie bekannt. Die aus dieser Schrift bekannten Projektionsobjektive umfassen fünf Linsengruppen, wobei die erste, zweite, dritte und fünfte Linsengruppe jeweils nur eine Linse aufweisen. Zum Teil sind die Linsen mit asphärischen Linsenoberflächen versehen, wobei auf einer in der vierten Linsengruppe bildseitig angeordnete asphärische Linsenoberfläche eine asphärische objektseitig angeordnete Linsenoberfläche der fünften Linsengruppe folgt.

Aus der EP 851 304 A2 ist die benachbarte Anordnung von asphärischen Linsenoberflächen in einem Projektionsobjektiv bekannt. Diese asphärischen Linsen sind in radialer Richtung verschiebbar gelagert. Durch die relative Bewegung der Linsen wird das Projektionsobjektiv abgestimmt. Aufgrund der Möglichkeit die Asphären in radialer Richtung gegeneinander zu verschieben sind die asphärischen Linsenoberflächen insbesondere rotationsunsymmetrisch. Aufgrund der beweglichen Lagerung der asphärischen Linsen, dürfte diese Anordnung nicht für jedes Projektionsobjektiv geeignet sein, da insbesondere für kurze Wellenlängen ausgelegte Projektionsobjektive sehr empfindlich aus kleinste Positionsänderungen der einzelnen Linsen reagieren. Es ist davon auszugehen, daß die durch die spezielle Lagerung der Linsen erreichbare Lagestabilität nicht ausreichend ist, um zuverlässig eine gute Abbildungsqualität gewährleisten zu können.

Aus der DE 198 18 444 A1 ist eine Projektionsoptikvorrichtung mit einem rein refraktivem Projektionsobjektiv bekannt, das sechs Linsengruppen G1 bis G6 umfaßt. Bei diesem Projektionsobjektiv weisen die Linsengruppen G1,G3 und G5positive Brechkraft auf. Die Linsengruppen G2,und G4 weisen negative Brechkraft auf. Für die Korrektur von Abbildungsfehlern weisen einige Linsen, insbesondere in der vierten und fünften Linsengruppe, asphärische Linsenoberflächen auf.

Aus der DE 199 42 281.8 sind weitere Projektionsbelichtungsobjektive, die sechs Linsengruppen aufweisen, wobei die zweite Linsengruppe und die vierte Linsengruppe negative Brechkraft aufweisen, bekannt. Bei den aus dieser Schrift bekannten Projektionsobjektiven sind Linsen mit asphärischen Linsenoberflächen vorzugsweise in den ersten drei Linsengruppen angeordnet, wobei zwischen den asphärischen Linsenoberflächen eine Mindestzahl von sphärischen Linsenoberflächen angeordnete sind. Dieser Mindestabstand zwischen den asphärischen Linsenoberflächen erschien erforderlich, damit die eingesetzten asphärischen Linsen optimale Wirkung entfalten.

Aus der US 4,871,237 ist es bereits bekannt, in Abhängigkeit vom barometrischen Druck ein Objektiv abzustimmen und zwar über den Brechungsindex eines Füllgases in Linsenzwischenräumen. Durch eine geeignete Kombination von Zwischenräumen können zum Beispiel sphärische Aberration, Koma und andere Bildfehler korrigiert werden.

Aus der US 5,559,584 ist es bekannt, bei einer Projektionsbelichtungsanlage zur Herstellung mikro strukturierter Bauteile in den Zwischenräumen zwischen einem Wafer und/oder einem Retikel und dem Projektionsobjektiv Schutzgas einzubringen.

Aus der US 6,075,653 sind Projektionszoomsysteme und Projektoren bekannt, die vier Linsengruppen umfassen. Dieses Projektionsobjektiv weist eine bildseitig angeordnete Linsengruppe G1 auf, die insgesamt negative Brechkraft aufweist und nur aus zwei Negativlinsen besteht.

Der Erfindung liegt die Aufgabe zugrunde ein Projektionsobjektiv und eine Projektionsbelichtungsanlage sowie ein Verfahren zur Herstellung von mikrostrukturierten Bauteile bereitzustellen, wobei diese im Hinblick auf die Abbildungsqualität und das Auflösungsvermögen verbessert sind. Weiterhin lag der Erfindung die Aufgabe zugrunde die Herstellungskosten zu reduzieren.

Die Aufgabe der Erfindung wird durch die in den Patentansprüchen 1 und 21 gegebenen Merkmale gelöst.

Durch die Maßnahme bei einem Projektionsobjektiv mit einer Mehrzahl an Linsen, wobei mindestens zwei benachbart zueinander angeordnete Linsenoberflächen asphärisch sind, die im folgenden mit Doppelasphäre bezeichnet werden, die Doppelasphäre in einem Abstand von mindestens dem maximalen Linsendurchmesser des Objektives entfernt von der Bildebene, insbesondere Waferebene beabstandet anzuordnen wobei der Abstand zwischen den asphärischen Linsenoberflächen der Doppelasphäre maximal dem halben Linsendurchmesser des mittleren Durchmessers der Doppelasphäre wurden die Abbildungsqualitäten eines Projektionsobjektives im Vergleich zu einem Projektionsobjektiv ohne solche Doppelasphären, verbessert werden. Insbesondere konnte bei einem refraktiven Projektionsobjektiv durch den Einsatz von mindestens einer Doppelasphäre die numerische Apertur gesteigert werden, indem der erste Bauch verkürzt wurde, so daß bei konstanter Länge des Projektionsobjektives der dritte Bauch eine Steigerung der numerischen Apertur bei von etwa 0,03 bis 0,05 erfährt.

Insbesondere bei rein refraktiven Projektionsobjektiven hat sich der Einsatz von Doppelasphären mit einer Anordnung in den ersten drei Linsengruppen als besonders vorteilhaft herausgestellt.

In Lithographieobjektiven gibt es ausgezeichnete Stellen, die auf schwer beherrschbare Aberrationen besonders gut wirken, wenn sie asphärisiert werden. Gerade dort ist es sinnvoll die Wirksamkeit an der entsprechenden Stell durch eine komplexe Asphärenfunktion besonders effektiv zu nutzen. Prädestiniert ist der Bereich der ersten Taille und das Ende des zweiten Bauches sowie Bereiche hinter der Blende. Da der technischen Realisierung von komplexen Asphären technisch Grenzen gesetzt sind, können die komplexen Asphärenfunktionen mittels Doppelashären realisiert werden. Dadurch wird eine noch weitergehende Korrektur möglich, wobei die Asphären der Doppelasphäre technisch realisierbar sind.

Weiterhin hat sich als vorteilhaft herausgestellt, als asphärische Linsenoberflächen der Doppelasphäre asphärische Linsenoberflächen vorzusehen, deren Radius der bestpassendsten sphärischen Linsenoberfläche, mit Hüllradius bezeichnet, sich nur wenig unterscheiden. Vorzugsweise weichen die Kehrwerte der Hüllradien oder Radien der Doppelasphären weniger als 30% voneinander ab. Als Bezugswert wird der Kehrwert des betragsmäßig größeren Radius herangezogen.

Es hat sich insbesondere als vorteilhaft herausgestellt, daß sich die Scheitelradien der asphärischen Linsenoberflächen der Doppelasphären in bezug auf den betragsmäßig größeren Scheitelradius um weniger als 30% unterscheiden.

Auf dem Gebiet der Mikrolithographie wird in der Entwicklung das Bestreben verfolgt die Auflösung zu erhöhen. Die Auflösung kann zum einen durch Steigerung der numerischen Apertur, Verwendung von immer kleiner werden Wellenlängen und auch durch Korrektur von auftretenden Abbildungsfehlern gesteigert werden. Für eine Steigerung der bildseitigen numerischen Apertur ist der bildseitig angeordnete letzte Bauch des Objektives zu vergrößern. Problematisch ist jedoch, daß für das Objektiv nur ein fest vorgegebener Bauraum zur Verfügung gestellt werden kann. Um also eine größere numerische Apertur bereitstellen zu können, ist es somit erforderlich in anderen Bereichen des Objektives Bauraum einzusparen.

Es hat sich nun als vorteilhaft herausgestellt, den für die Steigerung der numerischen Apertur erforderlichen Bauraum durch Verkürzung des ersten Bauches bereitzustellen, wobei durch den ersten Bauches insbesondere die Eingangstelezentrie und die Verzeichnung korrigiert wird. Durch die Maßnahme Doppelasphären einzusetzen, ist es möglich, die Eingangstelezentrie sowie die Verzeichnung mit geringen Mitteln und auf kurzer Distanz korrigieren zu können. Durch die Doppelasphäre wird eine variable Einstellung des Ortes auf kurzer Distanz bereitgestellt, wobei durch die Möglichkeit den Ort variieren zu können, die Verzeichnung korrigiert werden kann. Durch die flexible Beeinflußbarkeit des Winkels kann insbesondere die Eingangstelezentrie korrigiert werden.

Insbesondere durch den Einsatz einer Doppelasphäre bei einem refraktiven Projektionsobjektiv im Bereich der ersten beiden Linsengruppen, also bis einschließlich zur ersten Linsengruppe negativer Brechkraft, werden bereits Korrekturmittel im Eingangsbereich des Objektives bereitgestellt, so daß die in dem dritten Bauch erforderlichen Korrekturmittel für die Gewährleistung einer gleichbleibenden Abbildungsqualität reduziert sind.

Weiterhin kann durch Vorsehen einer Doppelasphäre im vorderen Bereich des Objektives, insbesondere bis zur 2. Taille, die Anzahl der Linsen reduziert werden. Dies wirkt sich vorteilhaft auf die Herstellungskosten aus.

Es hat sich zur Verbesserung der Abbildungsqualität bei rein refraktiven Projektionsobjektiven als vorteilhaft herausgestellt asphärischen Linsenoberflächen im vorderen Bereich des Objektives vor der zweiten Taille vorzusehen. So kann beispielsweise bei einer numerischen Apertur von 0,83 die Abweichung von der Wellenfront einer Kugelwelle auf weniger als 6 m$\lambda$, bei einem Feld von 8x26 mm$^2$ bezogen auf 248nm reduziert werden.

Durch Druckschwankungen des athmosphärischen Druckes können die Abbildungseigenschaften des Objektives verändert werden. Um solche Druckschwankungen zu kompensieren hat es sich als vorteilhaft herausgestellt, einen Zwischenraum zwischen zwei Linsenoberflächen gezielt mit Druck zu beaufschlagen, so daß Druckänderungen insbesondere des atmosphärischen Druckes ausgeglichen werden können. Weiterhin kann die gezielte Druckbeaufschlagung zur weiteren Verminderung von Abbildungsfehlern genutzt werden.

Weiterhin hat es sich als vorteilhaft herausgestellt, mindestens eine der Abschlußplatten mit einem Druckmanipulator zu versehen, so daß durch beidseitige Druckbeaufschlagung der jeweiligen Linse bzw. der jeweiligen Platte eine Wölbung der Platte bzw. Linse erzeugt werden kann. So kann bei einer Dreipunktlagerung der Abschlußplatte und Druckbeaufschlagung des Gasraumes gezielt mittels der Durchbiegung der Abschlußplatte die Dreiwelligkeit während des Betriebes korrigiert werden. Mit einer n-Punktlagerung ist somit eine n-Welligkeit korrigierbar. Durch koaxial angeordnete Aktuatoren, insbesondere Piezos, kann eine in Z-Richtung gerichtete Kraft zur Wölbung der Linse eingeleitet werden, wobei die von den Aktuatoren eingeleitete Kraft auf den Linsenmittelpunkt gerichtet ist.

Weitere vorteilhafte Maßnahmen sind in weiteren Unteransprüchen beschrieben.

Anhand der folgenden Ausführungsbeispiele wird die Erfindung näher erläutert.

Es zeigt:

Figur 1:     Projektionsbelichtungsanlage;

Figur 2:  Projektionsobjektiv für die Wellenlänge 157 nm mit einer numerischen Apertur von 0,8;

Figur 3:  Projektionsobjektiv für die Wellenlänge 248 nm mit einer numerischen Apertur von 0,83;

Figur 4:  Projektionsobjektiv für die Wellenlänge 248 nm mit einer numerischen Apertur von 0,9;

Figur 5:  Projektionsobjektiv für die Wellenlänge 193 nm mit der numerischen Apertur 0,85;

Figur 6:  Projektionsobjektiv für die Wellenlänge 193 nm mit einer numerischen Apertur von 0,9;

Figur 7:  Projektionsobjektiv für die Wellenlänge 157nm mit einer numerischen Apertur von 0,9;

Figur 8:  Projektionsobjektiv für die Wellenlänge 193 nm mit einer numerischen Apertur von 0,9; und

Figur 9:  Katadioptrisches Projektionsobjektiv mit Doppelasphäre für die Wellenlänge von 157 nm und mit einer numerischen Apertur von 0,8

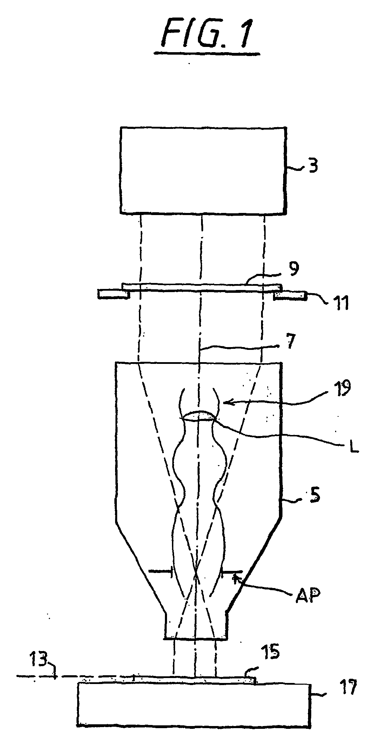

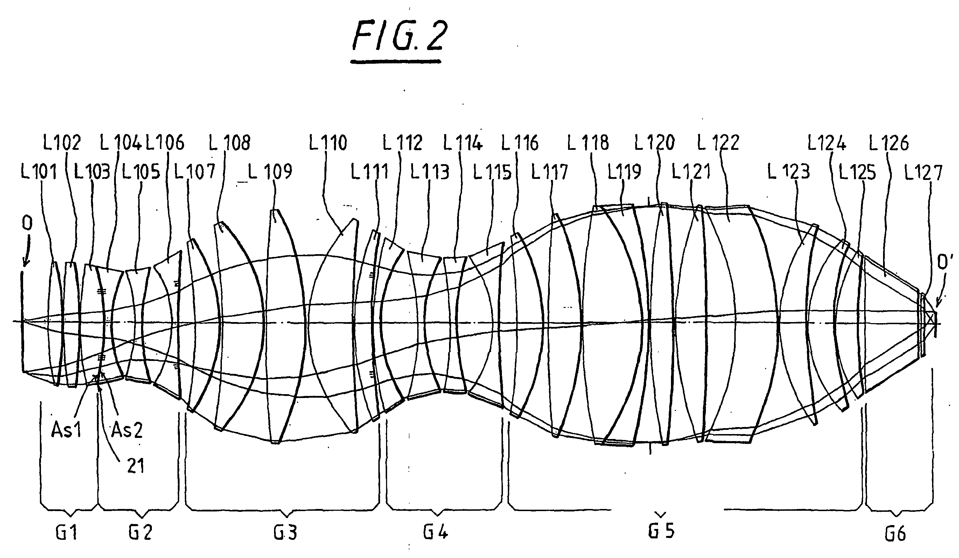

Anhand von Figur 1 wird zunächst der prinzipielle Aufbau einer Projektionsbelichtungsanlage beschrieben. Die Projektionsbelichtungsanlage 1, weist eine Beleuchtungseinrichtung 3 und Projektionsobjektiv 5 auf. Das Projektionsobjektiv 5 umfaßt eine Linsenanordnung 19 mit einer Aperturblende AP, wobei durch die Linsenanordnung 19 eine optische Achse 7 definiert wird. Verschiedene Linsenanordnungen werden nachfolgend anhand der Figuren 2 bis 6 näher erläutert. Zwischen Beleuchtungseinrichtung 3 und Projektionsobjektiv 5 ist eine Maske 9 angeordnet, die mittels eines Maskenhalters 11 im Strahlengang gehalten wird. Solche in der Mikrolithographie verwendete Masken 9 weisen eine Mikrometer-Nanometer Struktur auf, die mittels des Projektionsobjektives 5 bis zu einem Faktor von 10, insbesondere von um den Faktor 4, verkleinert auf eine Bildebene 13 abgebildet wird. In der Bildebene 13 wird ein durch einen Substrathalter 17 positionierte Substrat 15, bzw. ein Wafer, gehalten.

Die noch auflösbaren minimalen Strukturen hängen von der Wellenlänge $\lambda$ des für die Beleuchtung verwendeten Lichtes sowie von der bildseitigen numerischen Apertur des Projektionsobjektives 5 ab, wobei die maximal erreichbare Auflösung der Projektionsbelichtungsanlage 1 mit abnehmender Wellenlänge $\lambda$ der Beleuchtungseinrichtung 3 und mit zunehmender bildseitiger numerischer Apertur des Projektionsobjektives 5 steigt.

Das in Figur 2 dargestellte Projektionsobjektiv 19 umfaßt sechs Linsengruppen G1 bis G6. Dieses Projektionsobjektiv ist für die Wellenlänge 157 nm ausgelegt. Die erste Linsengruppe G1 wird durch die Linsen L101 bis L103, welche alle Bikonvexlinsen sind, gebildet. Diese erste Linsengruppe weist positive Brechkraft auf. Die letzte Linsenoberfläche dieser Linsengruppe G1, die bildseitig angeordnete ist, ist asphärisiert. Diese Linsenoberfläche wird mit AS 1 bezeichnet. Bei der letzten Linse dieser Linsengruppe G1 handelt es sich um eine bikonvexe Linse, die somit eindeutig der ersten Linsengruppe zuzuordnen ist.

Die sich an die Linsengruppe G1 anschließende Linsengruppe G2 umfaßt die drei Linsen L104 bis L106, wobei diese Linsengruppe G2 negative Brechkraft aufweist und eine Taille darstellt. Eine objektseitig angeordnete Linsenoberfläche AS2 der Linse L104 ist asphärisch. Weiterhin ist die bildseitig angeordnete Linsenoberfläche der Linse L106 asphärisch. Durch die beiden Linsenoberflächen AS1 und AS2 wird eine Doppelasphäre gebildet.

Die Linsengruppe G3, die positive Brechkraft aufweist, wird durch die Linsen L107 bis L111 gebildet, wobei die letzte Linsenoberfläche dieser Linsengruppe der Linse L111, die bildseitig angeordnet ist, asphärisiert ist.

An diese Linsengruppe schließt sich die zweite Linsengruppe G4 negativer Brechkraft an. Diese Linsengruppe G4 wird durch die Linsen L112 bis L115 gebildet.

Die fünfte Linsengruppe G5 mit den Linsen L116 bis L125, die positive Brechkraft aufweist, umfaßt eine Aperturblende AP, die zwischen der Linse L119 und der Linse L120 angeordnet ist.

Die sechste Linsengruppe G6 wird durch die Linsen bzw. Platten L126 und L127 gebildet. Bei diesem für die Wellenlänge 157 nm mit einer spektrale Bandbreite der Beleuchtungsquelle von 1,5 pm ausgelegte Objektiv sind die Linsen L113 bis L115 und L119 aus Natriumflourid. Durch den Einsatz von einem zweiten Material, hier Natriumflourid, können insbesondere chromatische Fehler korrigiert werden. Durch den Einsatz von NaF in der ersten Taille wird der Farbquerfehler wesentlich verringert verringert. Auch der Farblängsfehler wird etwas verringert, wobei durch den Einsatz von NaF in der Linsengruppe G5 der größte Einzelbeitrag zur Korrektur der Farblängsfehler erzielt wird.

Die sich an die Linsengruppe G4 anschließenden positiven Linsen L116 bis L118 der Linsengruppe G5 sind aus Lithiumflourid. Durch den Einsatz von Lithiumflourid an dieser Stelle im Objektiv wird insbesondere die monochromatische Korrektur erleichtert, da durch den größeren Dispersionsabstand von Lithium- und Natriumflourid als von Kalzium- und Natriumflourid nur kleine Einzelbrechkräfte zur Achromatisierung benötigt werden. Der grundsätzliche Aufbau unterscheidet sich aufgrund der speziellen Materialauswahl nicht so bedeutsam von einem chromatischen Objektiv.

Die beiden nach der Blende angeordneten positiven Linsen sind ebenfalls aus Lithiumflourid und leisten ebenfalls, wie schon anhand der vor der Blende angeordneten Lithiumlinsen erörtert, einen wichtigen Beitrag zur Korrektur des Farblängsfehlers.

Die Linse L122, deren beide Oberflächen nahezu im konstantem Abstand zueinander verlaufen, besteht aus Kalziumflourid. Diese Linse ist sehr bedeutsam für die monochromatische Korrektur und hat nur geringen Einfluß auf den chromatische Längsfehler.

Die letzten drei Linsen der fünften Linsengruppe G5 L123 bis L125 sind aus Lithiumflourid. Diese Linsen liefern zwar einen kleineren aber dennoch sehr wertvollen Beitrag zur Korrektur des Farblängsfehlers.

Die sechste Linsengruppe umfaßt die Linsen bzw. Planplatten L126 und L127, die aus Kalziumflourid bestehen.

Dieses Objektiv ist für die Beleuchtung eines Feldes von 8 x 26 mm ausgelegt. Die Baulänge betrat von 0 zu 0' 1000mm. Die numerische Apertur beträgt 0.8.Die genauen Linsendaten sind der Tabelle 1 zu entnehmen.

Die asphärischen Flächen werden in allen Ausführungsbeispielen durch die Gleichung:

$$P(h) = \frac{\delta \bullet h \bullet h}{1 + \sqrt{1 - (1 + K) \bullet \delta \bullet \delta \bullet h \bullet h}} + C_1 h^4 + ... + C_n h^{2n+2} \qquad \delta = 1/R$$

beschrieben, wobei P die Pfeilhöhe als Funktion des Radius h (Höhe zur optischen Achse 7) mit den in den Tabellen angegebenen asphärischen Konstanten $C_1$ bis $C_n$ ist R ist der in den Tabellen angegebene Scheitelradius.

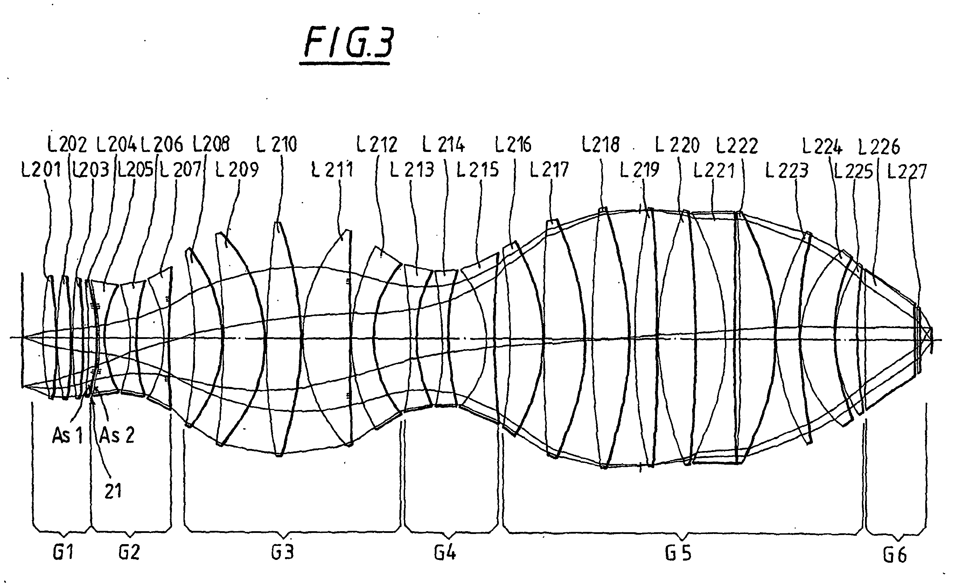

Das in Figur 3 dargestellte Projektionsobjektiv umfaßt sechs Linsengruppen G1 bis G6 mit den Linsen L201 bis L225 und einer geteilten Abschlußplatte L226, L227. Dieses Objektiv ist für die Beleuchtungswellenlänge 248nm ausgelegt. Der für dieses Projeküonsobjektiv 19 erforderliche Bauraum beträgt von Objektebene 0 bis Bildebene 0' genau 1000 mm. Bildseitig weist dieses Objektiv 19 eine numerische Apertur von 0,83 auf. Das mittels dieses Projektionsobjektives belichtbare Feld beträgt 8 x 26 mm.

Die erste Linsengruppe G1 umfaßt die Linsen L201 bis L204,wobei es sich bei den Linsen L201 bis 203 um Bikonvexlinsen handelt.

Die erste Linse L204 der Linsengruppe G1 weist auf der bildseitigen Linsenoberfläche eine asphärische Form auf. Diese Asphäre wird mit AS bezeichnet.

Die zweite LinsengruppeG2 umfaßt die drei Linsen L205 bis L207. Diese Linsen weisen bikonkave Form auf, wobei die jeweils zur angrenzenden Linsengruppe gewandte Linsenoberfläche der Linsen L205 und L207 asphärisch sind. Die asphärischen Linsenoberfläche der Linsen L205 wird mit AS2 bezeichnet. Damit wird durch die beiden zueinander gewandten asphärischen. Linsenoberflächen AS und AS2 eine Doppelasphäre gebildet. Die letzte Linse der Linsengruppe G2 ist waferseitig asphärisiert.

Die dritte Linsengruppe umfaßt die Linsen L208 bis L212. Durch diese Linsengruppe G3 wird ein Bauch gebildet. Die Linse L211 ist auf der bildseitigen Linsenoberfläche asphärisiert.

Die vierte Linsengruppe G4 wird durch die Linsen L213 bis L215 gebildet, die alle bikonkav ausgebildet sind. Diese Linsengruppe G4 ist die zweite Linsengruppe negativer Brechkraft. Durch diese Linsengruppe wird eine Taille gebildet.

Die Linsengruppe G5 umfaßt die Linsen L216 bis L225. Zwischen den Linsen L218 und L219 ist eine Aperturblende angeordnet. Die Blendenkrümmung beträgt zwischen Randstrahl an der Blende bei einer numerischen Apertur von 0,83 und dem Schnittpunkt des Hauptstrahls mit der optischen Achse 30,9 mm. Durch diese Linsengruppe wird ein Bauch gebildet.

Die sechste Linsengruppe G6 umfaßt die als Planplatten ausgebildeten Linsen L226 und L227.

Die genauen Linsendaten dieses Projektionsobjektives 19 sind der Tabelle 2 zu entnehmen. Gegenüber Figur 2 ist die Apertur bei gleichbleibender Baulänge des Objektives von 00' von 1000mm weiter auf 0,83 bei ausgezeichneter Korrektur gesteigert worden.

Das in Figur 4 gezeigte Projektionsobjektiv umfaßt sechs Linsengruppen mit den Linsen L301 bis L327. Dieses Objektiv ist für die Beleuchtungswellenlänge 248nm ausgelegt und weist eine numerische Apertur von 0,9 auf.

Die erste Linsengruppe G1 weist die Linsen L302 bis L303 auf. Diese Linsengruppe weist positive Brechkraft auf, wobei die Brechkraft insbesondere der Linsen L302 bis L303 sehr gering ist. Die Brennweite dieser Linsen beträgt bei L302 1077,874mm und bei L303 -92397,86mm.

An diese Linsengruppe schließt sich eine Linsengruppe negativer Brechkraft G2 an, die durch die drei Linsen L305 bis L307 gebildet wird. Die erste Linsenoberfläche dieser Linsengruppe G2, die bildseitig angeordnete ist, ist asphärisiert und wird mit AS1 bezeichnet. Die der Linsenoberfläche AS1 zugewandte Linsenoberfläche der Linse L305 ist asphärisiert, so daß durch die Linsenoberflächen AS1 und AS2 eine Doppelasphäre gebildet wird. Zwischen diesen asphärischen Linsenoberflächen AS1 und AS2 ist im Gegensatz zum vorangegangenen Ausführungsbeispiel ein deutlich erkennbarer Abstand vorgesehen. Bei dieser Doppelasphäre wird etwas die äquidistante Anordnung der Flächen AS1 und AS2 verlassen und die Doppelasphäre öffnet sich etwas nach außen.

Die darauffolgende Linsengruppe G3, die positive Brechkraft aufweist, umfaßt die Linsen L308 bis L311. Diese Linsengruppe G3 beinhaltet eine asphärische Linsenoberfläche, wobei diese asphärische Linsenoberfläche bildseitig auf der Linse L311 angeordnet ist.

Die zweite Linsengruppe negativer Brechkraft G4 umfaßt die Linsen L312 bis L315, wobei die bildseitig angeordnete Linsenoberfläche der Linse L314 asphärisiert ist.

Die sich anschließende Linsengruppe G5, die positive Brechkraft aufweist, umfaßt die Linsen L316 bis L325. Zwischen den Linsen L319 und L320 ist die Blende AP angeordnet. Die beiden zueinander gewandten Linsenoberflächen der Linsen L321 und L322 sind asphärisch und werden mit AS3 und AS4 bezeichnet. Durch diese Asphären AS3 und AS4 wird eine Doppelasphäre gebildet, wobei durch die Flächen AS1 und AS2 ein Luftraum eingeschlossen wird. Durch diese Doppelasphäre ist insbesondere die sphärische Abberation und die Sinusbedingung bei hohen Aperturen besser entkoppelt und gut zu korrigieren.

Die sechste Linsengruppe umfaßt die als dicke Planplatten ausgebildeten Linsen L326 und L327. Der durch diese Planplatten gebildete Zwischenraum ist mit Über- und Unterdruck und/oder mit einem Gas zur Kompensation von Schwankungen des atmosphärischen Druckes beaufschlagbar. Für weitergehende Korrekturmöglichkeiten kann es vorgesehen sein, daß mindestens eine der Planplatten mit oder ohne Brechkraft, also auch als Linse deutlich dünner, unter Druckvariation und Punktlagerung n-Welligkeiten kompensiert. Es könnten auch für eine gezielte Deformation der Linse am Außenumfang angreifende Piezoaktoren vorgesehen sein.

Die Baulänge dieses Objektives beträgt von Objektebene 0 zu Bildebene 0' 1139,8mm. Die numerische Apertur beträgt bildseitig 0,9 bei einem belichtbaren Feld von 27,2 mm in der Diagonalen. Die genauen Linsendaten sind der Tabelle 3 zu entnehmen.

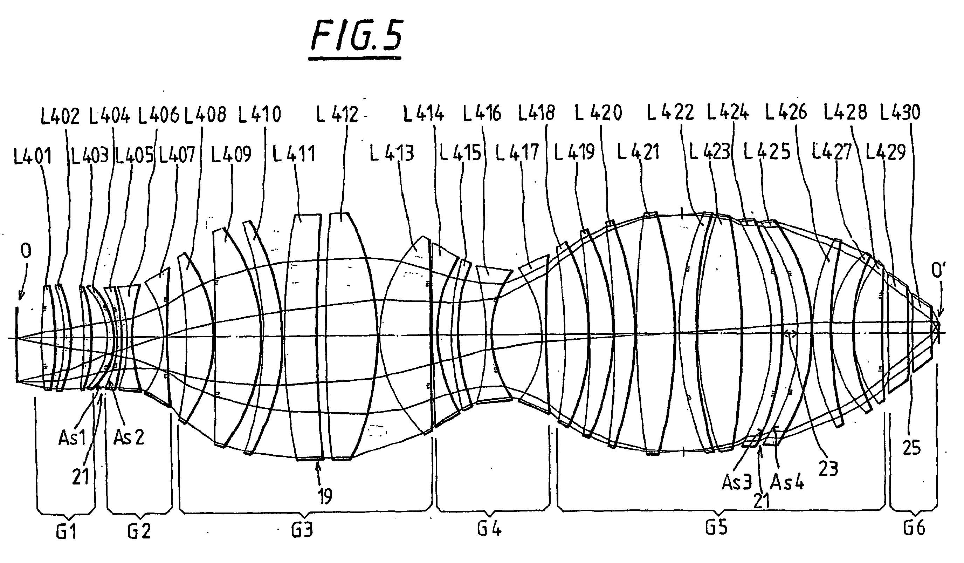

Das in Figur 5 dargestellt Projektionsobjektiv 19 umfaßt sechs Linsengruppen G1 bis G6. Dieses Projektionsobjektiv ist für die Wellenlänge 193nm ausgelegt. Die erste Linsengruppe G1 umfaßt die Linsen L401 bis L404. Bereits die erste, objektseitig angeordnete Linsenoberfläche der Linse L401 ist asphärisiert. Diese Asphäre wirkt sich insbesondere positiv auf Schalenverläufe und Verzeichnung bei guter Eingangstelezentrie aus, weil diese Asphäre an dem Ort angeordnet ist, an dem noch die beste Büscheltrennung bei dem hochaperturigen Lithographieobjektiv existiert.

Die objektseitig angeordnete Linsenoberfläche der Linse L404 ist asphärisch und wird mit AS1 bezeichnet. Durch diese Linsenoberfläche wird zusammen mit der bildseitig angeordneten Linsenoberfläche der Linse L405, die ebenfalls asphärisch ist und die mit AS2 bezeichnet ist, eine Doppelasphäre gebildet. Diese Doppelasphäre wirkt sich insbesondere positiv auf die Schalenverläufe bei gleichzeitiger guter Korrektur der durch die hohe Apertur bedingten Bildfehler aus. Die Flächen AS1 und AS2 der Doppelasphäre weisen mit zunehmendem radialem Abstand von der optischen Achse einen zunehmenden Abstand in Richtung der optischen Achse auf. Diese sich nach außen öffnende Doppelasphäre stellt ein komplexes Korrekturmittel bei mittlerer Büscheltrennung dar.

Die Linse L404 gehört bereits der zweiten Linsengruppe, die die Linsen L405 bis L407 umfaßt, an. Diese zweite Linsengruppe weist negative Brechkraft auf.

Die ersten Linsen L402 bis L405 weisen eine besonders geringe Brechkraft $f_{L402}$ = 1397,664mm, $f_{L403}$ = 509,911mm, $f_{L404}$ = 1371,145mm und $f_{L405}$ = -342,044mm auf. Eine weitere asphärische Linsenoberfläche ist bildseitig auf der Linse L407 vorgesehen.

Die darauffolgende Linsengruppe G3, die positive Brechkraft aufweist, umfaßt die Linsen L408 bis L413. Die Linsen L409 weist objektseitig eine asphärische Linsenoberfläche auf und die Linsen L413 ist bildseitig mit einer asphärischen Linsenoberfläche versehen. Die Asphäre L413 hat einen positiven Einfluß auf die Koma höherer Ordnung und auf die 45° Strukturen. Der zwischen den Linsen L411 und 412 vorgesehen Luftraum ist nahezu äquidistant.

Die Linsengruppe G4, die negative Brechkraft aufweist, wird durch die Linsen L414 bis L416 gebildet, wobei die Linse L415 bildseitig eine asphärische Linsenoberfläche aufweist. Diese asphärische Linsenoberfläche wirkt in einer guten Mischung auf apertur- und feldabhängige Bildfehler, insbesondere bei Objektiven mit einer hohen Apertur.

Die darauffolgende Linsengruppe G5 wird durch die Linsen L417 bis L427 gebildet. Zwischen den Linsen L420 bis L421 ist eine Blende AP angeordnet. Die auf die Blende AP folgende Linsenoberfläche der Linse L422 ist asphärisiert. Mit diese Asphäre wird es möglich die Korrektur der sphärischen Aberration, ohne andere Bildfehler zu beeinflussen, durchgeiuhrt. Dazu ist es aber notwendig bei anwesendheit von deutlicher Blendenkrümmung, daß die asphärische Fläche in den Bereich einer Schiebeblende hineinragt.

Weiterhin sind die zueinander gewandten Linsenoberflächen der Linsen L423 und L424 die mit AS3 und AS4 bezeichnet werden, asphärisiert. Durch diese nachfolgende Doppelasphäre ist insbesondere eine gute aplanatische Korrektur für höchste numerische Apertur möglich. Es ist also die gleichzeitige Korrektur der sphärischen Aberration und der Erfüllung der Sinusbedingung möglich.

Die Linsengruppe G6 wird durch die Linsen L428 bis L429, die als Planplatten ausgebildet sind, gebildet. Es kann wiederum vorgesehen sein, daß der Zwischenraum zwischen den planparallelen Platten 428 und 429 mit einem Fluid beaufschlagbar ist.

Als Linsenmaterial ist Quarzglas vorgesehen, wobei es zur Verminderung der chromatischen Aberration vorgesehen sein kann, daß die Linsen L408 und L409 sowie L413 aus Kalziumflourid bestehen. Zur Verminderung des Compaction-Effektes aufgrund der hohen Strahlungsbelastung kann es vorgesehen sein, für die kleinere oder für beide planparallelen Platten L428 und L429 als Material Kalziumflourid vorzusehen. Auffällig ist weiterhin bei diesem Projektionsobjektiv, däß der maximale Durchmesser der Linsengruppe G3 einen größeren maximalen Durchmesser als die Linsengruppe G5 mit 398mm aufweist. Dieses Objektiv ist sehr gut korrigiert und die Abweichung von der Wellenfront einer idealen Kugelwelle ist $> = 1,2$ m$\lambda$ bezogen auf 193nm. Der Abstand zwischen Objektebene 0 und Bildebene 0' beträgt 1188,1 mm und das belichtbare Feld beträgt 8 x 26 mm. Die genauen Linsendaten sind der Tabelle 4 zu entnehmen.

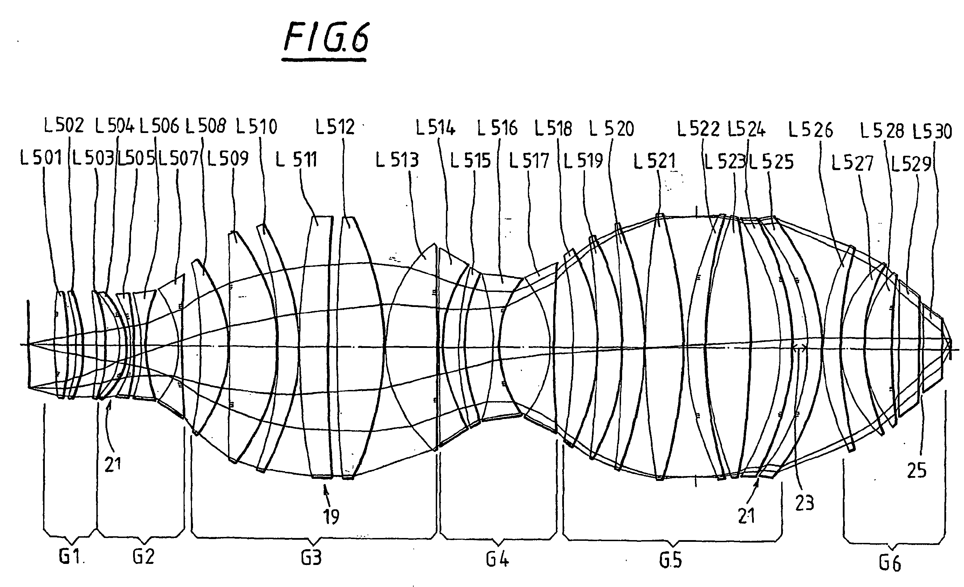

Das in Figur 6 dargestellte Projektionsobjektiv umfaßt die Linsengruppen G1 bis G6 mit den Linsen L501 bis L530, wobei für L529 und 530 Planplatten vorgesehen sind. Dieses Projektionsobjektiv ist für die Wellenlänge 193nm ausgelegt und weist eine numerische Apertur von 0,9 auf. Der Abstand zwischen Objektebene 0 und Bildebene 0' beträgt 1174,6 mm. Das belichtbare Feld umfaßt eine Größe von 8 x 26 mm. Makroskopisch betrachtet unterscheidet sich dieses Projektionsobjektiv von dem anhand von Figur 5 beschriebenen Projektionsobjektiv nicht. Wiederum weisen insbesondere die Linsen L502 und L503 geringe Brechkraft auf. Die Linse L510 ist hier, wie auch in dem vorangegangenen anhand von Figur 5 beschriebenen Projektionsobjektivs, insbesondere für die Quadratenkorrektur vorgesehen.

Abgesehen von den planparallelen Platten L529 und L530 bestehen alle Linsen L501 bis L528 aus Quarzglas. Auch dieses Projektionsobjektiv ist sehr gut korrigiert und die Abweichung von der idealen Wellenfront einer Kugelwelle ist $<$ als 3,0 m$\lambda$, bezogen auf 193nm. Die Linsen L510, L515, L522 weisen eine geringe Brechkraft auf. Die genauen Linsendaten sind der Tabelle 5 zu entnehmen. Die Wirkung der asphärischen Flächen entsprechen prinzipiell den anhand von Fig.5 beschriebenen Wirkungen, wobei die Wirkungen aufgrund der höheren numerischen Apertur von 0,9 noch stärker sind.

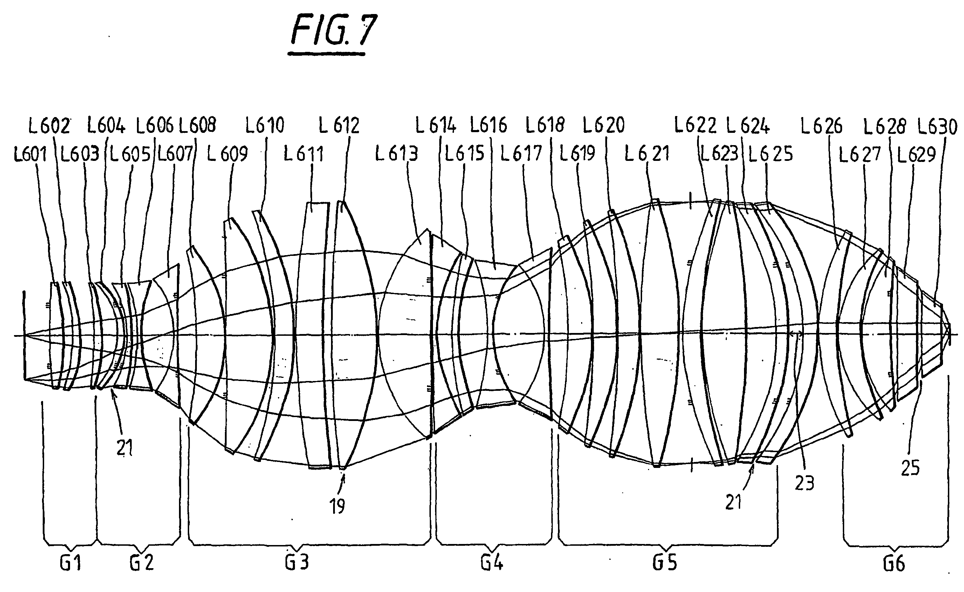

Das in Figur 7 für die Wellenlänge 157nm dargestellte Projektionsobjektiv umfaßt sechs Linsengruppen mit den Linsen L601 bis L630 mit den planparallelen Platten L629 und L630. Die Baulänge dieses Projektionsobjektives beträgt von Objektebene 0 bis zur Bildebene 0' 997,8 mm, wobei ein Feld von 7 x 22 mm belichtbar ist. Die numerische Apertur dieses Objektives beträgt 0,9. Als Linsenmaterial ist Kalziumflourid vorgesehen. Eine weitere Korrektur von Farbfehlern ist durch den Einsatz von Bariumflourid als Linsenmaterial für die Linsen L614 bis L617 erreichbar. Die Abweichung von der Wellenfront einer idealen Kugelwelle ist $< 1,8$ m$\lambda$ bezogen auf 157nm. Da makroskopisch betrachtet der Aufbau des in Figur 7 dargestellten Projektionsobjektives sich von den anhand von Figur 5 und Figur 6 beschriebenen Projektionsobjektiven nur geringfügig unterschieden wird, auf die Beschreibung insbesondere auf die Beschreibung zu Figur 5 verwiesen. Die exakten Linsendaten sind der Tabelle 6 zu entnehmen.

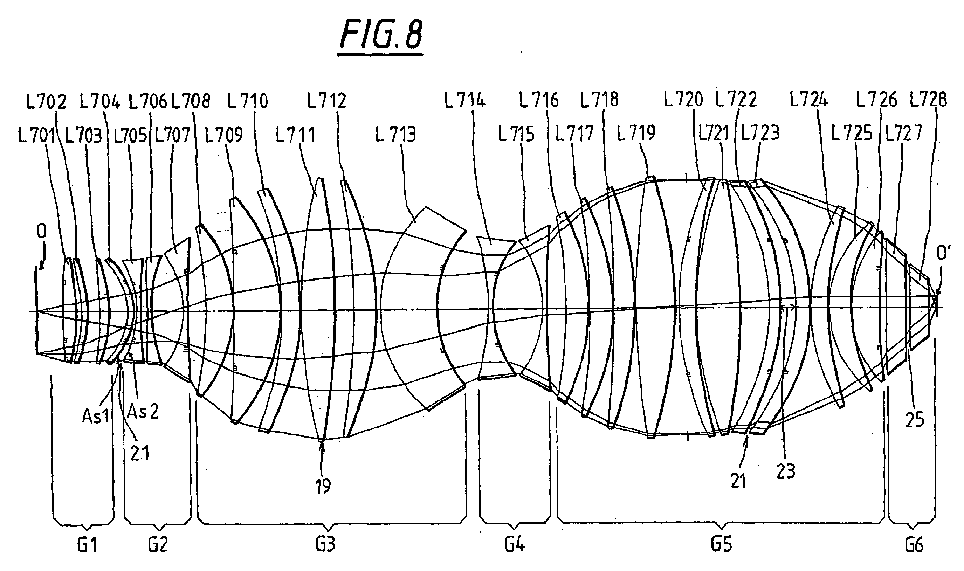

Das in Figur 8 dargestellte Projektionsobjektiv umfaßt 6 Linsengruppe G1-G6. Die erste Linsengruppe umfaßt die Linsen L701- L704, wobei die Linse L701 objektseitig und die Linse L704 bildseitig eine asphärische Linsenoberfläche aufweisen. Diese erste Linsengruppe weist nur Linsen positiver Brechkraft auf, die annähernd identischen Durchmessers sind.

Die darauf folgende zweite Linsengruppe G2, die negative Brechkraft aufweist, umfaßt die Linsen L705 - L708. Die Linse L705 weist auf der der Linse L704 zugewandten Seite eine asphärische Linsenoberfläche auf, mit AS2 bezeichnet. Durch die beiden asphärischen Linsenoberflächen AS1 und AS2 wird eine Doppelasphäre 21 gebildet. Diese Doppelasphäre ist zum Wafer durchgebogen und öffnet sich schwach in radialer Richtung. Weiterhin weist die Linse L708 bildseitig eine asphärische Linsenoberfläche auf.

Die dritte Linsengruppe G3 mit den Linsen L709 - L714 weist positive Brechkraft auf. Diese Linsengruppe umfaßt zwei asphärische Linsen L710 und L714. Der zwischen den Linsen L712 und L713 ausgebildete Luftspalt weist nahezu konstante Dicke auf.

Die vierte Linsengruppe G4 umfaßt nur zwei Negativlinsen L715 und L716, durch die eine Taille gebildet wird. Die Linse L715 ist bildseitig mit einer asphärischen Linsenoberfläche versehen.

Die fünfte Linsengruppe mit den Linsen L717 - L727 weist positive Brechkraft auf. Zwischen der Linse L720 und L721 ist die Blende AP angeordnet. In dieser Linsengruppe ist eine weitere Doppelasphäre 21 vorgesehen, die durch die beiden asphärischen Linsenoberflächen AS3 und AS4 der Linsen L723 und L724 gebildet wird. Weitere asphärische Linsenoberflächen sind auf der Linse L721 objektseitig und auf der Linse L727 bildseitig angeordnet.

An diese Linsengruppe schließt sich die letzte Linsengruppe G6, die durch die beiden planparallelen Platten L728 und L729 gebildet wird, an. Durch die zueinander gewandten Oberflächen der Planplatten L728 und L729 wird ein Zwischenraum 25, der mit Druck beaufschlagbar ist, gebildet.

Dieses Projektionsobjektiv ist für die Wellenlänge 193 nm ausgelegt und weist eine numerische Apertur von 0,9 auf. Der Abstand zwischen Objektebene 0 und Bildebene 0 - beträgt 1209,6 mm. Mit diesem Projektionsobjektiv ist ein Feld von 10,5 x 26 mm belichtbar. Die maximale Abweichung von der idealen Wellenfront einer Kugelwelle beträgt 3,0 m$\lambda$ bezogen auf 193nm. Diese Abweichung wurde mittels dem Programmcode CODE V ermittelt. Die genauen Linsendaten sind der Tabelle 7 zu entnehmen.

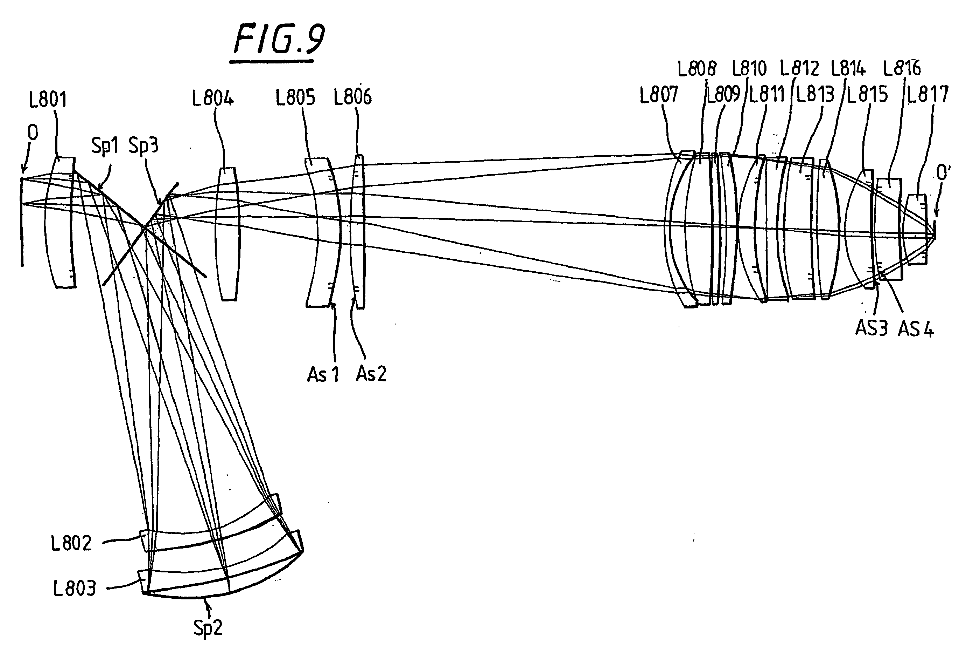

In Figur 9 ist ein katadioptrisches.Projektionsobjektiv das für die Wellenlänge 157 nm ausgelegt ist, dargestellt.

Mit diesem Projektionsobjektiv ist ein Feld von 22 x 7 mm belichtbar. Die numerische Apertur beträgt 0,8. Bei diesem Projektionsobjektiv bestehen alle Linsen als Kalziumfluorid. Die erste Linse L801 ist bildseitig mit einer asphärischen Linsenoberfläche versehen. Diese Asphäre liefert insbesondere einen wertvollen Beitrag zur Korrektur der Verzeichnung.

Über den Spiegel SP1 wird die Strahlung umgelenkt und trifft auf die Linse negativer Brechkraft L802. Die darauffolgende Linse L803 ist auf der im Strahlengang bildseitig angeordneten Linsenseite mit einer asphärischen Linsenoberfläche versehen. Diese Asphäre liefert einen besonders wertvollen Beitrag zur Korrektur von der sphärischen Aberration.

Die von der Linse L803 ausbreitende Strahlung wird an dem Spiegel SP2 zurückreflektiert und passiert die Linsen L803 und L802 in umgekehrter Reihenfolge, bevor sie durch Reflektion am Spiegel SP3 zur Linse L804, die auf einer mit der Linse L801 gemeinsamen optischen Achse angeordnet ist, zugeführt wird. Zwischen dem Spiegel SP3 und L804 entsteht ein Zwischenbild Z1. Die darauffolgenden Linsen L805 und L806 weisen an den zueinander gewandten Oberflächen asphärische Linsenoberflächen AS1 und AS2 auf. Durch diese Asphären wird eine Doppelasphäre gebildet. Weiterhin umfaßt das Objektiv die Linsen L807 - L818 wobei die Linsen L812, L814, L816 und L818 bildseitig mit einer asphärischen Linsenoberfläche versehen sind und die Linse L817 objektseitig mit einer asphärischen Linsenoberfläche versehen ist. Durch die asphärischen Linsenoberflächen der Linsen L816 und L817 wird eine Doppelasphäre gebildet.

Bezugszeichenliste

1. Projektionsbelichtungsanlage
3. Belichtungseinrichtung
5. Projektionsobjektiv
7. Optische Achse 9 Maske
11. Maskenhalter
13. Bildebene
15. Substrat, Wafer
17. Substrathalter AP = Aperturblende 19 Linsenanordung L = Linsen
19. Maximaler Radius
21. Doppelasphären
23. Abstand zwischen asphärischen Linsenoberflächen der Doppelasphären
25. Zwischenraum

**TABELLE 1** M1197a

| LINSEN | RADIEN | DICKEN | GLÄSER | BRECHZAHL BEI 157 nm | 1/2 FREIER DURCHMESSER |
|---|---|---|---|---|---|
| 0 | unendlich | 32.000000000 | N2 | 1.00000320 | 54.410 |
|  | unendlich | 3.386300000 | N2 | 1.00000320 | 61.189 |
| L101 | 331.163350000 | 17.963900000 | CaF2 | 1.55B40983 | 63.195 |
|  | -319.616060000 | 1.476400000 | N2 | 1.00000320 | 63.531 |
| L102 | 766.337390000 | 17.162600000 | CaF2 | 1.55840983 | 63.346 |
|  | -447.357070000 | 0.750000000 | N2 | 1.00000320 | 62.932 |
| L103 | 308.080750000 | 26.167800000 | CaF2 | 1.55840983 | 61.274 |
|  | -256.921560000AS | 0.781900000 | N2 | 1.00000320 | 59.279 |
| 104 | -199.459070000AS | 7.000000000 | CaF2 | 1.55840983 | 59.017 |
|  | 115.459900000 | 26.055700000 | N2 | 1.00000320 | 53.978 |
| L105 | -155.555940000 | 7.000000000 | CaF2 | 1.55840983 | 54.017 |
|  | 181.538670000 | 32.685400000 | N2 | 1.00000320 | 57.637 |
| L106 | -105.047550000 | 7.623100000 | CaF2 | 1.55840983 | 59.819 |
|  | -6182.626690000AS | 16.767300000 | N2 | 1.00000320 | 74.788 |
| L107 | -441.263450000 | 27.098000000 | CaF2 | 1.55840983 | 83.940 |
|  | -151.990780000 | 2.318200000 | N2 | 1.00000320 | 88.568 |
| L108 | -613.725250000 | 45.372400000 | CaF2 | 1.55840983 | 103.501 |
|  | -150.623730000 | 2.560000000 | N2 | 1.00000320 | 107.663 |

Tabelle fortgesetzt

| LINSEN | RADIEN | DICKEN | GLÄSER | BRECHZAHL BEI 157 nm | 1/2 FREIER DURCHMESSER |
|---|---|---|---|---|---|
| L109 | 1648.391330000 | 42.538400000 | CaF2 | 1.55840983 | 119.260 |
| | -255.166800000 | 2.852600000 | N2 | 1.00000320 | 120.183 |
| L110 | 154.432580000 | 47.915200000 | CaF2 | 1.55840983 | 110.475 |
| | 1162.400830000 | 0.929300000 | N2 | 1.00000320 | 107.883 |
| L111 | 261.100680000 | 20.383600000 | CaF2 | 1.55840983 | 98.431 |
| | 614.726380000AS | 0.867900000 | N2 | 1.00000320 | 93.917 |
| L112 | 359.575500000 | 7.168800000 | CaF2 | 1.55840983 | 89.668 |
| | 126.930570000 | 40.754900000 | N2 | 1.00000320 | 76.782 |
| L113 | -253.190760000 | 7.000000000 | NAF | 1.46483148 | 74.969 |
| | 132.038930000 | 28.180300000 | N2 | 1.00000320 | 67.606 |
| L114 | -338.990070000 | 7.611900000 | NAF | 1.46483148 | 67.535 |
| | 222.374240000 | 39.202700000 | N2 | 1.00000320 | 68.722 |
| L115 | -109.896940000 | 7.095700000 | NAF | 1.46483148 | 69.544 |
| | 705.107390000 | 19.428900000 | N2 | 1.00000320 | 84.312 |
| L116 | -706.158480000 | 29.677100000 | LIF | 1.47810153 | 90.890 |
| | -180.715990000 | 5.740400000 | N2 | 1.00000320 | 95.248 |
| L117 | 1725.475600000 | 35.904100000 | LIF | 1.47810153 | 112.495 |
| | -263.017160000 | 0.750000000 | N2 | 1.00000320 | 114.191 |
| L118 | 619.827930000 | 64.044600000 | LIF | 1.47810153 | 121.296 |
| | -197.026470000 | 0.750100000 | N2 | 1.00000320 | 121.844 |
| L119 | -195.861770000 | 7.000000000 | NAF | 1.46483148 | 121.626 |
| | -469.620100000 | 0.750000000 | N2 | 1.00000320 | 123.300 |
| | unendlich | 0.750600000 | N2 | 1.00000320 | 122.405 |
| L120 | 640.893310000 | 25.458500000 | LIF | 1.47810153 | 123.549 |
| | -1089.937900000 | 0.980400000 | N2 | 1.00000320 | 123.525 |
| L121 | 322.108140000 | 34.102200000 | LIF | 1.47810153 | 121.602 |
| | -1728.500990000 | 31.928200000 | N2 | 1.00000320 | 120.573 |
| L122 | -234.494140000 | 46.273400000 | CaF2 | 1.55840983 | 119.587 |
| | -251.236960000 | 0.974700000 | N2 | 1.00000320 | 121.785 |
| L123 | 171.211410000 | 29.502800000 | LIF | 1.47810153 | 103.953 |
| | 452.301450000 | 0.887100000 | N2 | 1.00000320 | 101.542 |
| L124 | 126.180740000 | 28.831400000 | LIF | 1.47810153 | 88.565 |
| | 223.894010000 | 0.796800000 | N2 | 1.00000320 | 83.098 |
| L125 | 132.333150000 | 25.819300000 | LIF | 1.47810153 | 76.140 |
| | 477.745080000 | 6.457300000 | N2 | 1.00000320 | 70.847 |
| L126 | unendlich | 59.682500000 | CaF2 | 1.55840983 | 69.261 |
| | Unendlich | 0.838600000 | N2 | 1.00000320 | 33.343 |
| L127 | unendlich | 4.000000000 | CaF2 | 1.55840983 | 32.211 |
| | Unendlich | 12.000810000 | N2 | 1.00000320 | 29.804 |
| L128 | unendlich | 0.000000000 | | | 13.603 |

ASPHAERISCHE KONSTANTEN

Asphäre der Linse L103

K      -0.8141

C1     -1.93290250e-007

C2     4.16659320e-011

Tabelle fortgesetzt

Asphäre der Linse L103

| | |
|---|---|
| C3 | -4.77885250e-015 |
| C4 | 3.28605790e-019 |
| C5 | -1.03537910e-022 |
| C6 | 2.39743010e-026 |
| C7 | 0.00000000e+000 |
| C8 | 0.00000000e+000 |
| C9 | 0.00000000e+000 |

Asphäre der Linse L104

| | |
|---|---|
| K | -1.0887 |
| C1 | 1.57414760e-008 |
| C2 | 1.63099500e-011 |
| C3 | -4.85048550e-015 |
| C4 | 9.48501060e-019 |
| C5 | -2.37918310e-022 |
| C6 | 3.60692700e-026 |
| C7 | 0.00000000e+000 |
| C8 | 0.00000000e+000 |
| C9 | 0.00000000e+000 |

Asphäre der Linse L106

| | |
|---|---|
| K | 4235.0115 |
| C1 | 1.16160120e-007 |
| C2 | -1.37360280e-011 |
| C3 | -1.75181710e-016 |
| C4 | 1.56917750e-019 |
| C5 | -1.57135270e-023 |
| C6 | 5.89614270e-028 |
| C7 | 0.00000000e+000 |
| C8 | 0.00000000e+000 |
| C9 | 0.00000000e+000 |

Asphäre der Linse L111

| | |
|---|---|
| K | 0.0000 |
| C1 | 1.35782560e-009 |
| C2 | -2.31506660e-013 |
| C3 | 2.14831120e-017 |
| C4 | -7.84495330e-022 |
| C5 | -4.23732680e-026 |
| C6 | 1.17366430e-031 |
| C7 | 0.00000000e+000 |
| C8 | 0.00000000e+000 |
| C9 | 0.00000000e+000 |

Brechzahl und Wellenlänge sind gegenüber Luft angegeben.

**TABELLE 2** M1159a

| LINSEN | RADIEN | DICKEN | GLÄSER | BRECHZAHL BEI 248.38 nm | 1/2 FREIER DURCHMESSER |
|---|---|---|---|---|---|
| 0 | unendlich | 32.000000000 | Luft | 0.99998200 | 54.410 |
|  | unendlich | 0.750000000 | Luft | 0.99998200 | 61.498 |
| L201 | 359.203085922 | 16.544139898 | SIO2 | 1.50837298 | 62.894 |
|  | -367.814285018 | 0.750000000 | Luft | 0.99998200 | 63.342 |
| L202 | 376.906582229 | 16.424149202 | SIO2 | 1.50837298 | 63.744 |
|  | -370.266896435 | 0.750000000 | Luft | 0.99998200 | 63.552 |
| L203 | 623.868133301 | 12.000921336 | SIO2 | 1.50837298 | 62.201 |
|  | -558.943539628 | 4.488271401 | Luft | 0.99998200 | 61.489 |
| L204 | -593.881163796 | 10.597937240- | SIO2 | 1.50837298 | 60.233 |
|  | -258.275165583AS | 1.300130829 | Luft | 0.99998200 | 59.503 |
| L205 | -195.528496730AS | 7.000000000 | SIO2 | 1.50837298 | 59.067 |
|  | 114.970814112 | 27.465616009 | Luft | 0.99998200 | 54.855 |
| L206 | -150.593037892 | 7.000000000 | SIO2 | 1.50837298 | 55.023 |
|  | 203.788990073 | 29.227930343 | Luft | 0.99998200 | 59.359 |
| L207 | -116.847756998 | 7.000000015 | SIO2 | 1.50837298 | 60.888 |
|  | -1029423.850607139AS | 26.431412586 | Luft | 0.99998200 | 74.043 |
| L208 | -433.333706324 | 29.900058462 | SIO2 | 1.50837298 | 89.733 |
|  | -145.855178517 | 0.750000000 | Luft | 0.99998200 | 93.351 |
| L209 | -740.439232493AS | 44.983538148 | SIO2 | 1.50837298 | 108.655 |
|  | -155.998681446 | 0.750000000 | Luft | 0.99998200 | 111.280 |
| L210 | 730.369450038 | 38.596890643 | SIO2 | 1.50837298 | 120.834 |
|  | -339.830855552 | 0.750000000 | Luft | 0.99998200 | 121.150 |
| L211 | 159.417768241 | 52.577878183 | SIO2 | 1.50837298 | 112.765 |
|  | 457732.591606731AS | 0.780542469 | Luft | 0.99998200 | 110.299 |
| L212 | 190.812012094 | 23.738591831 | SIO2 | 1.50837298 | 94.787 |
|  | 115.677643950 | 40.245663292 | Luft | 0.99998200 | 77.717 |
| L213 | -412.140976525 | 7.000000000 | SIO2 | 1.50837298 | 76.256 |
|  | 151.701098214 | 27.102188582 | Luft | 0.99998200 | 69.619 |
| L214 | -319.487543080 | 7.000000000 | SIO2 1.50837298 |  | 69.443 |
|  | 236.707933198 | 42.112032397 | Luft | 0.99998200 | 70.193 |
| L215 | -105.934259216 | 8.769693914 | SIO2 | 1.50837298 | 71.068 |
|  | 680.231460994 | 17.681829203 | Luft | 0.99998200 | 88.650 |
| L216 | -517.056865132 | 36.235608441 | SIO2 | 1.50837298 | 91.923 |
|  | -185.271735391 | 0.764865888 | Luft | 0.99998200 | 100.651 |
| L217 | 2262.402798068 | 44.431825566 | SIO2 | 1.50837298 | 119.658 |
|  | -267.329724617 | 8.198939895 | Luft | 0.99998200 | 123.247 |
| L218 | 1103.186796189 | 40.827914599 | SIO2 | 1.50837298 | 133.839 |
|  | -364.593909045 | 8.280602730 | Luft | 0.99998200 | 134.570 |
|  | unendlich | -3.250000000 | Luft | 0.99998200 | 133.180 |
| L219 | 620.770366318 | 25.036239346 | SIO2 | 1.50837298 | 134.241 |
|  | -1858.943929157 | 0.750000000 | Luft | 0.99998200 | 134.164 |
| L220 | 329.635686681 | 40.854820783 | SIO2 | 1.50837298 | 132.227 |
|  | -1181.581276955 | 31.972595866 | Luft | 0.99998200 | 131.156 |
| L221 | -249.799136729 | 10.000000000 | SIO2 | 1.50837298 | 130.229 |
|  | 6484.262988004 | 5.619260320 | Luft | 0.99998200 | 130.672 |
| L222 | -2574.687141000 | 38.775298966 | SIO2 | 1.50837298 | 130.696 |
|  | -254.665255526 | 0.750000000 | Luft | 0.99998200 | 130:891 |

Tabelle fortgesetzt

| LINSEN | RADIEN | DICKEN | GLÄSER | BRECHZAHL BEI 248.38 nm | 1/2 FREIER DURCHMESSER |
|---|---|---|---|---|---|
| L223 | 203.341746230 | 25.409827006 | SIO2 | 1.50837298 | 110.728 |
|  | 463.496973555 ' | 0.750000000 | Luft | 0.99998200 | 108.517 |
| L224 | 118.263098967 | 37.247858671 | SIO2 | 1.50837298 | 92.529 |
|  | 191.067427473 | 0.753637388 | Luft | 0.99998200 | 84.037 |
| L225 | 137.671384625 | 24.859589811 | SIO2 | 1.50837298 | 78.934 |
|  | 507.533271700 | 6.693359054 | Luft | 0.99998200 | 74.624 |
| L226 | unendlich | 55.768369688 | SIO2 | 1.50837298 | 72.833 |
|  | unendlich | 0.800000000 | Luft | 0.99998200 | 35.729 |
| L227 | unendlich | 4.000000000 | SIO2 | 1.50837298 | 34.512 |
|  | unendlich | 11.999970000 | Luft | 0.99998200 | 31.851 |
| L228 | unendlich | 0.000000000 |  | 1.00000000 | 13.602 |

ASPHAERISCHE KONSTANTEN

Asphäre der Linse L204

| K | -0.7780 |
|---|---|
| C1 | -1.91000417e-007 |
| C2 | 4.02870297e-011 |
| C3 | -5.55434626e-015 |
| C4 | 1.68245178e-019 |
| C5 | 2.20604311e-023 |
| C6 | 8.09599744e-027 |
| C7 | 0.00000000e+000 |
| C8 | 0.00000000e+000 |
| C9 | 0.00000000e+000 |

Asphäre der Linse L205

| K | -0.4166 |
|---|---|
| C1 | 5.25344324e-008 |
| C2 | 1.26756433e-011 |
| C3 | -5.25489404e-015 |
| C4 | 7.04023970e-019 |
| C5 | -1.04520766e-022 |
| C6 | 2.06454806e-026 |
| C7 | 0.00000000e+000 |
| C8 | 0.00000000e+000 |
| C9 | 0.00000000e+000 |

Asphäre der Linse L207

| K | -2116959451.7820 |
|---|---|
| C1 | 1.25171476e-007 |
| C2 | -1.53794245e-011 |
| C3 | -3.12532578e-016 |
| C4 | 2.00967035e-019 |
| C5 | -2.05026124e-023 |

Tabelle fortgesetzt

Asphäre der Linse L207
C6      7.81326379e-028


Asphäre der Linse L211
K       0.0000
C1      2.78321477e-009
C2      5.89866335e-014
C3      1.19811527e-017
C4      -7.81165149e-022
C5      1.66111023e-026
C6      -1.60965484e-031


Brechzahl und Wellenlänge sind in Luft bestimmt worden.

**TABELLE 3** M1222a

| LINSEN | RADIEN | DICKEN | GLÄSER | BRECHZAHL BEI 248.380nm | 1/2 FREIER DURCHMESSER |
|---|---|---|---|---|---|
| 0 | unendlich | 32.000000000 | L710 | | 54.410 |
| | unendlich | 0.750000000 | L710 | | 62.206 |
| L301' | 12444.588054076 | 17.524945114 | SIO2 | 1.50837298 | 62.427 |
| | -167.739069307 | 0.765384867 | L710 | 0.99998200 | 63.213 |
| L302 | 1202.845295516 | 8.943027554 | SIO2 | 1.50837298 | 63.724 |
| | -1004.036633539 | 0.757676170 | L710 | 0.99998200 | 63.750 |
| L303 | 235.865591780 | 9.298971429 | SIO2 | 1.50837298 | 63.464 |
| | 231.568686620 | 24.888929767 | L710 | 0.99998200 | 62.457 |
| L304 | -148.910928631 | 11.307968350 | SIO2 | 1.50837298 | 62.393 |
| | -106.056725042AS | 11.531057240 | L710 | 0.99998200 | 63.087 |
| L305 | -135.467082619AS | 7.000000000 | SIO2 | 1.50837298 | 60.496 |
| | 236.063635384 | 11.820516442 | L710 | 0.99998200 | 61.104 |
| L306 | -1613.154189634 | 7.000000000 | SIO2 | 1.50837298 | 61.565 |
| | 222.732790977 | 38.103480975 | 1,710 | 0.99998200 | 63.842 |
| L307 | -93.477889742 | 7.004909948 | SIO2 | 1.50837298 | 64.855 |
| | 10625258.126273967AS | 25.183324680 | L710 | 0.99998200 | 84.949 |
| L308 | -313.395232213 | 37.921288357 | SIO2 | 1.50837298 | 94.853 |
| | -140.728421777 | 2.422311655 | L710 | 0.99998200 | 102.129 |
| L309 | -882.714069478AS | 62.983288381 | SIO2 | 1.50837298 | 129.319 |
| | -162.454752849 | 0.750000000 | L710 | 0.99998200 | 131.820 |
| L310 | 372.954030958 | 61.566328910 | SIO2 | 1.50837298 | 148.956 |
| | -446.221051696 | 0.750000000 | L710 | 0.99998200 | 148.766 |
| L311 | 159.626550846 | 68.423222152 | SIO2 | 1.50837298 | 126.219 |
| | 6881.817080351AS | 0.754846049 | L710 | 0.99998200 | 121.302 |
| L312 | 1035.238560782 | 11.490813397 | SIO2 | 1.50837298 | 116.908 |
| | 181.491627420 | 22.008897360 | L710 | 0.99998200 | 97.838 |
| L313 | 508.638145894 | 7.024491847 | SIO2 | 1.50837298 | 96.444 |
| | 144.727315074 | 42.480962349 | L710 | 0.99998200 | 85.818- |
| L314 | -315.769132147 | 7.000000000 | SIO2 | 1.50837298 | 85.132 |
| | 168.042488686AS | 60.840114041 | L710 | 0.99998200 | 82.384 |
| L315 | -110.641058959 | 7.0000000.00 | SIO2 | 1.50837298 | 82.821 |
| | 460.993264759 | 26.383956624 | L710 | 0.99998200 | 108.073 |
| L316 | -573.887503383 | 33.664255268 | SIO2 | 1.50837298 | 111.503 |

Tabelle fortgesetzt

| LINSEN | RADIEN | DICKEN | GLÄSER | BRECHZAHL BEI 248.380nm | 1/2 FREIER DURCHMESSER |
|---|---|---|---|---|---|
| | -189.203245467 | 0.750000000 | L710 | 0.99998200 | 115.508 |
| L317 | -4374.531790288 | 33.200388364 | SIO2 | 1.50837298 | 144.129 |
| | -365.840916872 | 0.750000000 | L710 | 0.99998200 | 146.400 |
| L318 | 53-67.437754049 | 32.001020330 | SIO2 | 1.50837298 | 162.024 |
| | -556.194479444 | 0.857496674 | L710 | 0.99998200 | 163.414 |
| L319 | 1425.923295786 | 68.540751990 | SIO2 | 1.50837298 | 172.847 |
| | -318.608860176 | 8.280602730 | L710 | 0.99998200 | 173.674 |
| | unendlich | -3.250000000 | L710 | 0.99998200 | 165.236 |
| L320 | 524.088279104 | 18.000000000 | SIO2 | 1.50837298 | 164.278 |
| | 896.107746530 | 0.750000000 | L710 | 0.99998200 | 163.371 |
| L321 | 447.468508944 | 50.493798307 | SIO2 | 1.50837298 | 161.574 |
| | -849.886554129 | 37.700767601 | L710 | 0.99998200 | 160.560 |
| L322 | -277.232722440 . | 15.000000000 | SIO2 | 1.50837298 | 159.396 |
| | -359.067701243AS | 13.800352685 | L710 | 0.99998200 | 159.582 |
| L323 | -283.705002828AS | 20.143173981 | SIO2 | 1.50837298 | 158.903 |
| | -264.293409160 | 0.750000000 | L710 | 0.99998200 | 159.923 |
| L324 | 182.924856302 | 28.086938401 | SIO2 | 1.50837298 | 124.917 |
| | 293.542915952 | 0.750000000 | L710 | 0.99998200 | 122.192 |
| L325 | 138.051507251 | 29.667601165 | SIO2 | 1.50837298 | 107.973 |
| | 206.495592035 | 4.518697859 | L710 | 0.99998200 | 103.815 |
| L326 | 137.608373914 | 37.703252491 | SIO2 | 1.50837298 | 93.169 |
| | 2008.206929102AS | 6.230615100 | L710 | 0.99998200 | 88.838 |
| L327 | 79833.713358573 | 27.734587521 | SIO2 | 1.50837298 | 83.516 |
| | unendlich | 5.000000000 | L710 | 0.99998200 | 62.961 |
| L328 | unendlich | 25.000000000 | SIO2 | 1.50837298 | 52.694 |
| | unendlich | 10.000000000 | L710 | 0.99998200 | 34.137 |
| L329 | unendlich | 0.000000000 | | | 13.605 |

L710 = Luft bei 710 Torr = 950 mbar

ASPHAERISCHE KONSTANTEN

Asphäre der Linse L304

K     -1.5058
C1    -1.86740544e-007
C2    3.71500406e-011
C3    -8.38153156e-015
C4    1.06034402e-018
C5    -7.88993246e-023
C6    2.81358334e-027
C7    0.00000000e+000
C8    0.00000000e+000
C9    0.00000000e+000

Asphäre der Linse L305

K     -1.3497
C1    9.59200710e-008

Tabelle fortgesetzt

Asphäre der Linse L305

| | |
|---|---|
| C2 | 3.31187872e-011 |
| C3 | -1.02270060e-014 |
| C4 | 1.45048880e-018 |
| C5 | -1.18276835e-022 |
| C6 | 5.49446108e-027 |
| C7 | 0.00000000e+000 |
| C8 | 0.00000000e+000 |
| C9 | 0.00000000e+000 |

Asphäre der Linse L307

| | |
|---|---|
| K | -23427671857767355000000000000.0000 |
| C1 | 1.13856265e-007 |
| C2 | -9.18910043e-012 |
| C3 | -2.09482944e-016 |
| C4 | 8.75414269e-020 |
| C5 | -6.71659158e-024 |
| C6 | 1.94896163e-028 |
| C7 | 0.00000000e+000 |
| C8 | 0.00000000e+000 |
| C9 | 0.00000000e+000 |

Asphäre der Linse L311

| | |
|---|---|
| K | 0.0000 |
| C1 | 1.36987424e-008 |
| C2 | -6.69820602e-013 |
| C3 | 2.24912373e-017 |
| C4 | -5.16548278e-022 |
| C5 | 4.05832389e-027 |
| C6 | 3.25008659e-032 |
| C7 | 0.00000000e+000 |
| C8 | 0.00000000e+000 |
| C9 | 0.00000000e+000 |

Asphäre der Linse L314

| | |
|---|---|
| K | 0.0000 |
| C1 | -3.81602557e-009 |
| C2 | -1.32998252e-012 |
| C3 | 0.00000000e+000 |
| C4 | -3.24422613e-021 |
| C5 | 3.55600124e-025 |
| C6 | -2.11130790e-029 |
| C7 | 0.00000000e+000 |
| C8 | 0.00000000e+000 |
| C9 | 0.00000000e+000 |

Asphäre der Linse L322

| | |
|---|---|
| K | 0.0000 |
| C1 | 2.20018047e-011 |
| C2 | -6.06720907e-016 |
| C3 | -1.85544385e-019 |
| C4 | 1.99332533e-023 |
| C5 | -1.25615823e-028 |
| C6 | 5.72017494e-033 |
| C7 | 0.00000000e+000 |
| C8 | 0.00000000e+000 |
| C9 | 0.00000000e+000 |

Asphäre der Linse L323

| | |
|---|---|
| K | 0.0000 |
| C1 | 2.59747415e-011 |
| C2 | 1.15845870e-015 |
| C3 | 2.93792021e-019 |
| C4 | -5.20753147e-024 |
| C5 | 5.15087863e-028 |
| C6 | -3.68361393e-033 |
| C7 | 0.00000000e+000 |
| C8 | 0.0000000e+000 |
| C9 | 0.00000000e+000 |

Asphäre der Linse L326

| | |
|---|---|
| K | 0.0000 |
| C1 | 2.53574810e-008 |
| C2 | 1.14136997e-012 |
| C3 | -2.09898773e-016 |
| C4 | 1.80771983e-020 |
| C5 | -8.70458993e-025 |
| C6 | 1.83743606e-029 |
| C7 | 0.00000000e+000 |
| C8 | 0.00000000e+000 |
| C9 | 0.00000000e+000 |

**TABELLE 4** M1450a

| LINSEN | RADIEN | DICKEN | GLÄSER | BRECHZAHL BEI 193.304nm | 1/2 FREIER DURCHMESSER |
|---|---|---|---|---|---|
| 0 | unendlich | 32.000000000 | L710 | 0.99998200 | 54.410 |
| | unendlich | 0.700000000 | L710 | 0.99998200 | 61.369 |
| L401 | 1072.135967906AS | 17.638366552 | SIO2 | 1.56028895 | 62.176 |
| | -274.850778792 | 10.038841436 | HE | 0.99971200 | 62.804 |
| L402 | -195.160258125 | 9.677862773 | S102 | 1.56028895 | 62.822 |
| | -159.034954419 | 15.411706951 | HE | 0.99971200 | 63.649 |
| L403 | -409.040910955 | 11.634800854 | SIO2 | 1.56028895 | 62.424 |
| | -184.929247238 | 18.878098976 | HE | 0.99971200 | 62.549 |
| L404 | -86.928681017 | 9.000000000 | SIO2 | 1.56028895 | 61.870 |

Tabelle fortgesetzt

| LINSEN | RADIEN | DICKEN | GLÄSER | BRECHZAHL BEI 193.304nm | 1/2 FREIER DURCHMESSER |
|---|---|---|---|---|---|
|  | -81.003682870AS | 3.559685814 | HE | 0.99971200 | 63.469 |
| L405 | -105.055795110AS | 6.000000000 | SIO2 | 1.56028895 | 60.375 |
|  | -237.059668556 | 7.135710642 | HE | 0.99971200 | 61.325 |
| L406 | -170.390902140 | 6.000000000 | SIO2 | 1.56028895 | 61.152 |
|  | 179.617978310 | 40.187039625 | HE | 0.99971200 | 64.312 |
| L407 | -108.910057000 | 6.000000000 | SIO2 | 1.56028895 | 66.769 |
|  | 10000.000000000AS | 23.032466424 | HE | 0.99971200 | 84.010 |
| L408 | -482.423484275 | 35.657870541 | SIO2 | 1.56028895 | 98.271 |
|  | -166.024534852 | 0.712083613 | HE | 0.99971200 | 104.636 |
| L409 | -5301.825985682AS | 59.184134830 | SIO2 | 1.56028895 | 129.868 |
|  | -219.603781546 | 1.964238192 | HE | 0.99971200 | 135.616 |
| L410 | -407.514819861 | 25.000000000 | SIO2 | 1.56028895 | 141.192 |
|  | -275.650807138 | 2.073256156 | HE | 0.99971200 | 143.933 |
| L411 | 812.482278880 | 41.728126549 | SIO2 | 1.56028895 | 150.437 |
|  | 2085.321083022 | 11.867512800 | HE | 0.99971200 | 150.588 |
| L412 | 1989.395979432 | 66.189720990 | SIO2 | 1.56028895 | 151.170 |
|  | -336.825131023 | 2.208063283 | HE | 0.99971200 | 151.249 |
| L413 | 161.751335222 | 66.140524993 | SIO2 | 1.56028895 | 121.860 |
|  | -7743.125302019AS | 0.732008617 | HE | 0.99971200 | 115.257 |
| L414 | 2700.830058670 | 8.000000000 | SIO2 | 1.56028895 | 112.928 |
|  | 175.482298866 | 18.681794864 | HE | 0.99971200 | 94.204 |
| L415 | 330.479176880 | 8.000000000 | SIO2 | 1.56028895 | 91.933 |
|  | 215.492418517 | 37.734500801 | HE | 0.99971200 | 86.259 |
| L416 | -263.077268094 | 6.000000000 | SIO2 | 1.56028895 | 83.596 |
|  | 119.453498304AS | 66.406324570 | HE | 0.99971200 | 77.915 |
| L417 | -126.431526615 | 6.000000000 | SIO2 | 1.56028895 | 80.395 |
|  | 1627.715124622 | 24.178532080 | HE | 0.99971200 | 96.410 |
| L418 | -517.066851877 | 30.987035837 | SIO2 | 1.56028895 | 105.371 |
|  | -242.666474401 | 0.700000000 | HE | 0.99971200 | 113.249 |
| L419 | -737.673536297 | 30.292644418 | SIO2 | 1.56028895 | 124.350 |
|  | -270.925750340 | 0.700000000 | HE | 0.99971200 | 128.112 |
| L420 | -1051.979110054 | 27.301344542 | SIO2 | 1.56028895 | 137.231 |
|  | -363.545320262 | 0.711035404 | HE | 0.99971200 | 139.644 |
| L421 | 914.456821676 | 50.497126159 | SIO2 | 1.56028895 | 148.531 |
|  | -500.741001160 | 10.000000000 | HE | 0.99971200 | 149.700 |
| L422 | unendlich | -5.000000000 | HE | 0.99971200 | 146.693 |
|  | 353.826401507AS | 22.748234242 | SIO2 | 1.56028895 | 147.721 |
| L423 | 529.864238000 | 1.376970242 | HE | 0.99971200 | 146.294 |
|  | 422.718681400 | 57.709521396 | SIO2 | 1.56028895 | 146.003 |
| L424 | -733.506899438 | 31.321473463 | HE | 0.99971200 | 143.238 |
|  | -261.264462802 | 15.000000000 | SIO2 | 1.56028895 | 138.711 |
| L425 | -292.145870649AS | 18.942285163 | HE | 0.99971200 | 139.089 |
|  | -225.638240671AS | 19.098948274 | SIO2 | 1.56028895 | 136.464 |
| L426 | -230.537827019 | 0.700000000 | HE | 0.99971200 | 138.299 |
|  | 246.284141218 | 23.038665896 | SIO2 | 1.56028895 | 114.892 |
| L427 | 400.381969987 | 0.704537226. | HE | 0.99971200 | 110.931 |
|  | 131.458744675 | 28.653621426 | SIO2 | 1.56028895 | 98.090 |
| L428 | 200.500973816 | 0.708148286 | HE | 0.99971200 | 93.130 |
|  | 139.428371855 | 36.540725215 | SIO2 | 1.56028895 | 87.103 |

Tabelle fortgesetzt

| LINSEN | RADIEN | DICKEN | GLÄSER | BRECHZAHL BEI 193.304nm | 1/2 FREIER DURCHMESSER |
|--------|--------|--------|--------|-------------------------|------------------------|
| L429 | 1188.104646109AS | 8.107454155 | HE | 0.99971200 | 79.764 |
| | unendlich | 25.934594077 | CaF2 | 1.50143563 | 72.791 |
| L430 | unendlich | 5.000000000 | L710 | 0.99998200 | 54.980 |
| | unendlich | 25.000000000 | CAF2HL | 1.50143563 | 46.911 |
| L431 | unendlich | 10.000000000 | L710 | 0.99998200 | 29.741 |
| | unendlich | 0.000000000 | | | 13.603 |

L710 = Luft bei 710 Torr

ASPHAERISCHE KONSTANTEN

Asphäre der Linse L401

| K | 0.0000 |
|---|--------|
| C1 | 7.64628377e-008 |
| C2 | 6.87967706e-013 |
| C3 | 6.32367166e-017 |
| C4 | 4.65534082e-020 |
| C5 | -1.74760583e-023 |
| C6 | 3.25143184e-027 |
| C7 | -2.97366674e-031 |
| C8 | 0.00000000e+000 |
| C9 | 0.00000000e+000 |

Asphäre der Linse L404

| K | -1.3306 |
|---|--------|
| C1 | -2.46704917e-007 |
| C2 | 1.00943626e-011 |
| C3 | -6.88338440e-015 |
| C4 | 1.00927351e-018 |
| C5 | -1.37371749e-022 |
| C6 | 9.94732480e-027 |
| C7 | -6.46127195e-031 |
| C8 | 0.00000000e+000 |
| C9 | 0.00000000e+000 |

Asphäre der Linse L405

| K | -1.1682 |
|---|--------|
| C1 | 8.44108642e-008 |
| C2 | 6.67934072e-012 |
| C3 | -5.16053049e-015 |
| C4 | 8.51835178e-019 |
| C5 | -9.37525700e-023 |
| C6 | 3.80738193e-027 |
| C7 | -7.58518933e-035 |
| C8 | 0.00000000e+000 |
| C9 | 0.00000000e+000 |

Asphäre der Linse L407

| K | 0.0000 |
|---|---|
| C1 | 8.18369639e-008 |
| C2 | -9.75131236e-012 |
| C3 | 3.85197305e-016 |
| C4 | 1.05024918e-020 |
| C5 | -3.84907914e-024 |
| C6 | 3.28329458e-028 |
| C7 | -1.16692413e-032 |
| C8 | 0.00000000e+000 |
| C9 | 0.00000000e+000 |

Asphäre der Linse L409

| K | 0.0000 |
|---|---|
| C1 | 4.21547093e-009 |
| C2 | -2.05810358e-013 |
| C3 | -2.19266732e-018 |
| C4 | -7.83959176e-023 |
| C5 | 6.55613544e-027 |
| C6 | -7.33103571e-032 |
| C7 | -2.15461419e-036 |
| C8 | 0.00000000e+000 |
| C9 | 0.00000000e+000 |

Asphäre der Linse L413

| K | 0.0000 |
|---|---|
| C1 | 1.39800416e-008 |
| C2 | -1.91505190e-013 |
| C3 | -1.26782008e-017 |
| C4 | 9.937782OOe-022 |
| C5 | -5.55824342e-026 |
| C6 | 1.85230750e-030 |
| C7 | -2.83026055e-035 |
| C8 | 0.00000000e+000 |
| C9 | 0.00000000e+000 |

Asphäre der Linse L416

| K | 0.0000 |
|---|---|
| C1 | -1.87949694e-008 |
| C2 | -4.87119675e-012 |
| C3 | -5.90009367e-017 |
| C4 | -5.76749530e-021 |
| C5 | -3.07189672e-025 |
| C6 | 4.51160541e-029 |
| C7 | -5.02037364e-033 |
| C8 | 0.00000000e+000 |
| C9 | 0.00000000e+000 |

Asphäre der Linse L421

| K | -0.0073 |
|---|---|
| C1 | 1.63581145e-010 |
| C2 | -7.80915457e-015 |
| C3 | 6.72460331e-021 |
| C4 | 5.33479719e-025 |
| C5 | 2.82144185e-028. |
| C6 | -6.16219372e-033 |
| C7 | 2.37157562e-037 |
| C8 | 0.00000000e+000 |
| C9 | 0.00000000e+000 |

Asphäre der Linse L424

| K | 0.0000 |
|---|---|
| C1 | 1.28367898e-010 |
| C2 | -1.18938455e-014 |
| C3 | -1.84714219e-019 |
| C4 | 4.28587779e-023 |
| C5 | -1.39213579e-027 |
| C6 | 2.04883718e-032 |
| C7 | -3.36201584e-037 |
| C8 | 0.00000000e+000 |
| C9 | 0.00000000e+000 |

Asphäre der Linse L425

| K | 0.0000 |
|---|---|
| C1 | -2.31584329e-010 |
| C2 | 2.47013162e-014 |
| C3 | 1.13928751e-018 |
| C4 | -1.24997826e-023 |
| C5 | -9.59653919e-028 |
| C6 | 1.46403755e-032 |
| C7. | -1.23684921e-037 |
| C8 | 0.00000000e+000 |
| C9 | O.OOOOOOOOe+000 |

Asphäre der Linse L428

| K | 0.0000 |
|---|---|
| C1 | 2.79193914e-008 |
| C2 | 5.72325985e-013 |
| C3 | -1.69156262e-016 |
| C4 | 1.45062961e-020 |
| C5 | -7.24157687e-025 |
| C6 | 1.59130857e-029 |
| C7 | 9.07975701e-035 |
| C8 | 0.00000000e+000 |
| C9 | 0.00000000e+000 |

**TABELLE 5** M1558a

| LINSEN | RADIEN | DICKEN | GLÄSER | BRECHZAHL BEI 193.304nm | 1/2 FREIER DURCHMESSER |
|---|---|---|---|---|---|
| 0 | unendlich | 32.000000000 | L710 | 0.99998200 | 54.410. |
| | unendlich | 0.700000000 | L710 | 0.99998200 | 61.800 |
| L501 | 1062.826934956AS | 17.734965551 | SIO2 | 1.56028895 | 62.680 |
| | -280.649155373 | 9.921059017 | HE | 0.99971200 | 63.358 |
| L502 | -198.612797944 | 9.733545477 | SIO2 | 1.56028895 | 63.454 |
| | -157.546275141 | 15.417407860 | HE | 0.99971200 | 64.281 |
| L503 | -400.277413338 | 11.803054495 | SIO2 | 1.56028895 | 63.163 |
| | -182.515287485 | 19.059582585 | HE | 0.99971200 | 63.316 |
| L504 | -86.486413985 | 9.000000000 | SIO2 | 1.56028895 | 62.723 |
| | -79.976798205AS | 3.314115561 | HE | 0.99971200 | 64.356 |
| L505 | -102.262183494AS | 6.000000000 | SIO2 | 1.56028895 | 61.260 |
| | -275.242312561 | 7.844485351 | HE | 0.99971200 | 62.494 |
| L506 | -191.274205909 | 6.000000000 | SIG2 | 1.56028895 | 62.450 |
| | 180.723494008 | 40.175681177 | HE | 0.99971200 | 65.811 |
| L507 | -108.539011643 | 6.000000000 | SIO2 | 1.56028895 | 67.752 |
| | 10000.000000000AS | 23.009626916 | HE | 0.99971200 | 86.379 |
| L508 | -481.040730284 | 35.657298256 | SIO2 | 1.56028895 | 100.931 |
| | -165.828518942 | 0.700000000 | HE | 0.99971200 | 106.719 |
| L509 | -5243.952853546AS | 59.233771719 | SIO2 | 1.56028895 | 134.666 |
| | -218.541408733 | 2.123657562 | HE | 0.99971200 | 139.441 |
| L510 | -402.136827778 | 25.000000000 | SIO2 | 1.56028895 | 145.856 |
| | -276.854279724 | 1.637353303 | HE | 0.99971200 | 148.618 |
| L511 | 796.304534481 | 36.805305429 | SIO2 | 1.56028895 | 156.741 |
| | 2360.950907095 | 10.808883416 | HE | 0.99971200 | 157.059 |
| L512 | 2256.926430541 | 60.789786196 | SIO2 | 1.56028895 | 157.684 |
| | -336.450738373 | 0.801676910 | HE | 0.99971200 | 157.856 |
| L513 | 161.617552542 | 66.152351274 | SIO2 | 1.56028895 | 125.624 |
| | -6835.350709889AS | 0.744366824 | HE | 0.99971200 | 121.362 |
| L514 | 2851.162473443 | 8.000000000 | SIO2 | 1.56028895 | 118.726 |
| | 173.208226906 | 18.750820117 | HE | 0.99971200 | 97.559 |
| L515 | 318.351302869 | 8.000000000 | SIO2 | 1.56028895 | 95.703 |
| | 214.643166184 | 38.151364608 | HE | 0.99971200 | 89.760 |
| L516 | -261.549915460 | 6.000000000 | SIO2 | 1.56028895 | 88.331 |
| | 119.510683982AS | 66.550546342 | HE | 0.99971200 | 82.116 |
| L517 | -126.322271364 | 6.000000000 | SIO2 | 1.56028895 | 83.464 |
| | 1722.207555551 | 24.185704173 | HE | 0.99971200 | 102.415 |
| L518 | -506.819064828 | 30.988960270 | SIO2 | 1.56028895 | 111.113 |
| | -242.042046428 | 0.700000000 | HE | 0.99971200 | 118.861 |
| L519 | -728.789614455 | 30.297084361 | SIO2 | 1.56028895 | 132.704 |
| | -269.518093553 | 0.700000000 | HE | 0.99971200 | 135.576 |
| L520 | -1024.754284774 | 27.306923440 | SIO2 | 1.56028895 | 147.201 |
| | -361.037355343 | 0.700000000 | HE | 0.99971200 | 149.061 |
| L521 | 929.096482269 | 49.082091976 | SIO2 | 1.56028895 | 161.109 |
| | -497.886578908 | 15.000000000 | HE | 0.99971200 | 161.854 |
| | unendlich | -10.000000000 | HE | 0.99971200 | 158.597 |
| L522 | 352.973470359AS | 22.735479730 | SIO2 | 1.56028895 | 159.957 |
| | 529.864238000 | 1.119499649 | HE | 0.99971200 | 158.688 |
| L523 | 422.718681400 | 57.532074113 | SIO2 | 1.56028895 | 158.278 |

Tabelle fortgesetzt

| LINSEN | RADIEN | DICKEN | GLÄSER | BRECHZAHL BEI 193.304nm | 1/2 FREIER DURCHMESSER |
|---|---|---|---|---|---|
|  | -733.230538894 | 37.317449332 | HE | 0.99971200 | 156.533 |
| L524 | -261.165349728 | 15.000000000 | SIO2 | 1.56028895 | 155.119 |
|  | -292.119447959AS | 18.962883498 | HE | 0.99971200 | 156.043 |
| L525 | -226.263316842AS | 19.009003051 | SIO2 | 1.56028895 | 155.000 |
|  | -231.163516914 | 0.700000000 | HE | 0.99971200 | 157.710 |
| L526 | 245.306778718 | 23.024380018 | SIO2 | 1.56028895 | 124.547 |
|  | 403.694577141 | 0.700000000 | HE | 0.99971200 | 121.262 |
| L527 | 132.188567375 | 28.647981266 | SIO2 | 1.56028895 | 10.4.696 |
|  | 199.679919884 4 | 0.700019350 | HE | 0.99971200 | 101.254 |
| L528 | 138.967602414 | 36.537553325 | SIO2 | 1.56028895 | 93.617 |
|  | 1194.093826692AS | 8.108769689 | HE | 0.99971200 | 89.148 |
| L529 | unendlich | 25.923824338 | CaF2 | 1.50143563 | 82.715 |
|  | unendlich | 5.000000000 | L710 | 0.99998200 | 63.301 |
| L530 | unendlich | 25.000000000 | CaF2 | 1.50143563 | 52.976 |
|  | unendlich | 10.000000000 | L710 | 0.99998200 | 34.253 |
| L531 | unendlich | 0.000000000 |  |  | 13.603 |

L710 = Luft bei 710 Torr

ASPHAERISCHE KONSTANTEN

Asphäre der Linse L501

| K | 0.0000 |
|---|---|
| C1 | 7.79889739e-008 |
| C2 | 5.96475035e-013 |
| C3 | 5.73397945e-017 |
| C4 | 5.38600405e-020 |
| C5 | -2.08145188e-023 |
| C6 | 4.05094979e-027 |
| C7 | -3.79132983e-031 |
| C8 | 0.00000000e+000 |
| C9 | 0.00000000e+000 |

Asphäre der Linse L504

| K | -1.3308 |
|---|---|
| C1 | -2.46633450e-007 |
| C2 | 1.00446806e-011 |
| C3 | .-7.00686898e-015 |
| C4 | 9.90840734e-019 |
| C5 | -1.31781718e-022 |
| C6 | 9.28901869e-027 |
| C7 | -6.52628587e-031 |
| C8 | 0.00000000e+000 |
| C9 | 0.00000000e+000 |

Asphäre der Linse L505

| | |
|---|---|
| K | -1.1513 |
| C1 | 8.27765089e-008 |
| C2 | 7.00992841e-012 |
| C3 | -5.19825762e-015 |
| C4 | 8.12467102e-019 |
| C5 | -8.31805913e-023 |
| C6 | 2.18925711e-027 |
| C7 | 1.11778799e-031 |
| C8 | 0.00000000e+000 |
| C9 | 0.00000000e+000 |

Asphäre der Linse L507

| | |
|---|---|
| K | 0.0000 |
| C1 | 8.22829380e-008 |
| C2 | -9.72735758e-012 |
| C3 | 3.85643753e-016 |
| C4 | 1.01114314e-020 |
| C5 | -3.91221853e-024 |
| C6 | 3.39732781e-028 |
| C7 | -1.20135313e-032 |
| C8 | 0.00000000e+000 |
| C9 | 0.00000000e+000 |

Asphäre der Linse L509

| | |
|---|---|
| K | 0.0000 |
| C1 | 9.14637283e-009 |
| C2 | -2.13253257e-013 |
| C3 | -2.08003643e-018 |
| C4 | -7.83152213e-023 |
| C5 | 5.30015388e-027 |
| C6 | -2.59321154e-033 |
| C7 | -3.37000758e-036 |
| C8 | 0.00000000e+000 |
| C9 | 0.00000000e+000 |

Asphäre der Linse L513

| | |
|---|---|
| K | 0.0000 |
| C1 | 1.39567662e-008 |
| C2 | -2.05760928e-013 |
| C3 | -1.29919990e-017 |
| C4 | 1.00302455e-021 |
| C5 | -5.58828742e-026 |
| C6 | 1.79594589e-030 |
| C7 | -2.49374487e-035 |
| C8 | 0.00000000e+000 |
| C9 | 0.00000000e+000 |

Asphäre der Linse L516

| K  | 0.0000 |
|----|--------|
| C1 | -1.82058286e-008 |
| C2 | -4.87410470e-012 |
| C3 | -5.89919068e-017 |
| C4 | -4.04061992e-021 |
| C5 | -6.60202054e-025 |
| C6 | 9.31855676e-029 |
| C7 | -7.48573635e-033 |
| C8 | 0.00000000e+000 |
| C9 | 0.00000000e+000 |

Asphäre der Linse L522

| K  | -0.0071 |
|----|---------|
| C1 | 1.64455895e-010 |
| C2 | -7.76483415e-015 |
| C3 | 8.29256873e-021 |
| C4 | -5.46990406e-025 |
| C5 | 3.42070772e-028 |
| C6 | -8.24545949e-033 |
| C7 | 2.57783363e-037 |
| C8 | 0.00000000e+000 |
| C9 | 0.00000000e+000 |

Asphäre der Linse L524

| K  | 0.0000 |
|----|--------|
| C1 | 1.18780021e-010 |
| C2 | -1.18823445e-014 |
| C3 | -1.80162246e-019 |
| C4 | 4.08343213e-023 |
| C5 | -1.42735407e-027 |
| C6 | 2.34804331e-032 |
| C7 | -3.79018523e-037 |
| C8 | 0.00000000e+000 |
| C9 | 0.00000000e+000 |

Asphäre der Linse L525

| K  | 0.0000 |
|----|--------|
| C1 | -2.15560895e-010 |
| C2 | 2.44929281e-014 |
| C3 | 1.12359306e-018 |
| C4 | -1.29749910e-023 |
| C5 | -1.00106399e-027 |
| C6 | 1.88165471e-032 |
| C7 | -2.01557723e-037 |
| C8 | 0.00000000e+000 |
| C9 | 0.00000000e+000 |

Asphäre der Linse L528

| | |
|---|---|
| K | 0.0000 |
| C1 | 2.73896476e-008 |
| C2 | 6.17281255e-013 |
| C3 | -1.75474902e-016 |
| C4 | 1.56329449e-020 |
| C5 | -8.82259694e-025 |
| C6 | 2.92948124e-029 |
| C7 | -4.01055770e-034 |
| C8 | 0.00000000e+000 |
| C9 | 0.00000000e+000 |

**TABELLE 6** M1587a

| LINSEN | RADIEN | DICKEN | GLÄSER | BRECHZAHL BEI 157.629nm | 1/2 FREIER DURCHMESSER |
|---|---|---|---|---|---|
| 0 | unendlich | 27.171475840 | N2 | 1.00031429 | 46.200 |
| | unendlich | 0.602670797 | N2 | 1.00031429 | 52.673 |
| L601 | 900.198243311AS | 15.151284556 | CaF2 | 1.55929035 | 53.454 |
| | -235.121108435 | 9.531971079 | N2 | 1.00031429 | 54.049 |
| L602 | -167.185917779 | 8.294716452 | CaF2 | 1.55929035 | 54.178 |
| | -132.673519510 | 14.020355779 | N2 | 1.00031429 | 54.901 |
| L603 | -333.194588652 | 9.893809820 | CaF2 | 1.55929035 | 53.988 |
| | -155.450516203 | 15.930502944 | N2 | 1.00031429 | 54.132 |
| L604 | -73.572316296 | 7.641977580 | CaF2 | 1.55929035 | 53.748 |
| | -68.248613899AS | 2.881720302 | N2 | 1.00031429 | 55.167 |
| L605 | -86.993585564AS | 5.094651720 | CaF2 | 1.55929035 | 52.580 |
| | -238.150965327 | 5.379130780 | N2 | 1.00031429 | 53.729 |
| L606 | -165.613920870 | 5.094651720 | CaF2 | 1.55929035 | 53.730 |
| | 153.417884485 | 34.150169591 | N2 | 1.00031429 | 56.762 |
| L607 | -92.061009990 | 5.094651720 | CaF2 | 1.55929035 | 58.081 |
| | 8491.086261873AS | 19.673523795 | N2 | 1.00031429 | 74.689 |
| L608 | -407.131300451 | 30.380807138 | CaF2 | 1.55929035 | 87.291 |
| | -140.620317156 | 0.761662684 | N2 | 1.00031429 | 91.858 |
| L609 | -4831.804853654AS | 50.269660218 | CaF2 | 1.55929035 | 117.436 |
| | -192.197373609 | 1.688916911 | N2 | 1.00031429 | 121.408 |
| L610 | -367.718684892 | 21.227715500 | CaF2 | 1.55929035 | 127.704 |
| | -233.628547894 | 2.224071019 | N2 | 1.00031429 | 129.305 |
| L611 | 709.585855080 | 28.736922725 | CaF2 | 1.55929035 | 137.016 |
| | 1238.859445357 | 9.120684720 | N2 | 1.00031429 | 137.428 |
| L612 | 1205.457051945 | 49.281218258 | CaF2 | 1.55929035 | 138.288 |
| | -285.321880705 | 1.625271224 | N2 | 1.00031429 | 138.379 |
| L613 | 137.549591710 | 56.718543740 | CaF2 | 1.55929035 | 108.652 |
| | -4380.301012978AS | 0.623523902 | N2 | 1.00031429 | 106.138 |
| L614 | 2663.880214408 | 6.792868960 | CaF2 | 1.55929035 | 103.602 |
| | 149.184979730 | 15.779049257 | N2 | 1.00031429 | 84.589 |
| L615 | 281.093108064 | 6.792868960 | CaF2 | 1.55929035 | 83.373 |
| | 184.030288413 | 32.341552355 | N2 | 1.00031429 | 77.968 |
| L616 | -222.157416308 | 5.094651720 | CaF2 | 1.55929035 | 77.463 |
| | 101.254238115AS | 56.792834221 | N2 | 1.00031429 | 71.826 |
| L617 | -106.980638018 | 5.094651720 | CaF2 | 1.55929035 | 72.237 |

Tabelle fortgesetzt

| LINSEN | RADIEN | DICKEN | GLÄSER | BRECHZAHL BEI 157.629nm | 1/2 FREIER DURCHMESSER |
|---|---|---|---|---|---|
|  | 1612.305471130 | 20.581065398 | N2 | 1.00031429 | 89.760 |
| L618 | -415.596135628 | 26.398111993 | CaF2 | 1.55929035 | 96.803 |
|  | -204.680044631 | 0.713343960 | N2 | 1.00031429 | 103.409 |
| L619 | -646.696622394 | 25.867340760 | CaF2 | 1.55929035 | 116.636 |
|  | -231.917626896 | 0.766268682 | N2 | 1.00031429 | 118.569 |
| L620 | -790.657607677 | 23.400482872 | CaF2 | 1.55929035 | 128.806 |
|  | -294.872053725 | 0.721402031 | N2 | 1.00031429 | 130.074 |
| L621 | 786.625567756 | 40.932308205 | CaF2 | 1.55929035 | 141.705 |
|  | -431.247283013 | 12.736629300 | N2 | 1.00031429 | 142.089 |
|  | unendlich | -8.491086200 | N2 | 1.00031429 | 134.586 |
| L622 | 295.022653593AS | 20.185109438 | CaF2 | 1.55929035 | 139.341 |
|  | 449.912291916 | 0.619840486 | N2 | 1.00031429 | 137.916 |
| L623 | 358.934076212 | 48.662890509 | CaF2 | 1.55929035 | 136.936 |
|  | -622.662988878 | 30.955714157 | N2 | 1.00031429 | 135.288 |
| L624 | -224.404889753 | 12.736629300 | CaF2 | 1.55929035 | 134.760 |
|  | -251.154571510AS | 16.079850229 | N2 | 1.00031429 | 134.853 |
| L625 | -193.582989843AS | 16.510083506 | CaF2 | 1.55929035 | 134.101 |
|  | -198.077570749 | 0.880353872 | N2 | 1.00031429 | 136.109 |
| L626 | 206.241795157 | 19.927993542 | CaF2 | 1.55929035 | 101.240 |
|  | 338.140581666 | 0.925956949 | N2 | 1.00031429 | 97.594 |
| L627 | 111.017549581 | 24.580089962 | CaF2 | 1.55929035 | 85.023 |
|  | 169.576109839 | 0.777849447 | N2 | 1.00031429 | 81.164 |
| L628 | 117.982165264 | 31.161065630 | CaF2 | 1.55929035 | 75.464 |
|  | 921.219058213AS | 6.934980174 | N2 | 1.00031429 | 69.501 |
| L629 | unendlich | 22.260797322 | CaF2 | 1.55929035 | 63.637 |
|  | unendlich | 4.245543100 | N2 | 1.00031429 | 48.606 |
| L630 | unendlich | 21.227715500 | CaF2 | 1.55929035 | 41.032 |
|  | unendlich | 8.491086200 | N2 | 1.00031429 | 26.698 |
|  | unendlich | 0.000000000 |  | 1.00000000 | 11.550 |

Wellenlänge und Brechzahl sind gegenüber Vakuum angegeben.

ASPHAERISCHE KONSTANTEN

Asphäre der Linse L601

| K | 0.0000 |
|---|---|
| C1 | 1.28594437e-007 |
| C2 | 8.50731836e-013 |
| C3 | 1.16375620e-016 |
| C4 | 2.28674275e-019 |
| C5 | -1.23202729e-022 |
| C6 | 3.32056239e-026 |
| C7 | -4.28323389e-030 |
| C8 | 0.00000000e+000 |
| C9 | 0.00000000e+000 |

Asphäre der Linse L604

| K  | -1.3312          |
|----|------------------|
| C1 | -4.03355456e-007 |
| C2 | 2.25776586e-011  |
| C3 | -2.19259878e-014 |
| C4 | 4.32573397e-018  |
| C5 | -7.92477159e-022 |
| C6 | 7.57618874e-026  |
| C7 | -7.14962797e-030 |
| C8 | 0.00000000e+000  |
| C9 | 0.00000000e+000  |

Asphäre der Linse L605

| K  | -1.1417          |
|----|------------------|
| C1 | 1.33637337e-007  |
| C2 | 1.56787758e-011  |
| C3 | -1.64362484e-014 |
| C4 | 3.59793786e-018  |
| C5 | -5.11312568e-022 |
| C6 | 1.70636633e-026  |
| C7 | 1.82384731e-030  |
| C8 | 0.00000000e+000  |
| C9 | 0.00000000e+000  |

Asphäre der Linse L607

| K  | 0.0000           |
|----|------------------|
| C1 | 1.34745120e-007  |
| C2 | -2.19807543e-011 |
| C3 | 1.20275881e-015  |
| C4 | 4.39597377e-020  |
| C5 | -2.37132819e-023 |
| C6 | 2.87510939e-027  |
| C7 | -1.42065162e-031 |
| C8 | 0.00000000e+000  |
| C9 | 0.00000000e+000  |

Asphäre der Linse L609

| K  | 0.0000           |
|----|------------------|
| C1 | 6.85760526e-009  |
| C2 | -4.84524868e-013 |
| C3 | -6.28751350e-018 |
| C4 | -3.72607209e-022 |
| C5 | 3.25276841e-026  |
| C6 | -4.05509974e-033 |
| C7 | -3.98843079e-035 |
| C8 | 0.00000000e+000  |
| C9 | 0.00000000e+000  |

Asphäre der Linse L613

| K | 0.0000 |
|---|---|
| C1 | 2.24737416e-008 |
| C2 | -4.45043770e-013 |
| C3 | -4.10272049e-017 |
| C4 | 4.31632628e-021 |
| C5 | -3.27538237e-025 |
| C6 | 1.44053025e-029 |
| C7 | -2.76858490e-034 |
| C8 | 0.00000000e+000 |
| C9 | 0.00000000e+000 |

Asphäre der Linse L616

| K | 0.0000 |
|---|---|
| C1 | -2.83553693e-008 |
| C2 | -1.12122261e-011 |
| C3 | -2.05192812e-016 |
| C4 | -1.55525080e-020 |
| C5 | -4.77093112e-029 |
| C6 | 8.39331135e-028 |
| C7 | -8.97313681e-032 |
| C8 | 0.-00000000e+000 |
| C9 | 0.00000000e+000 |

Asphäre der Linse L622

| K | 0.0421 |
|---|---|
| C1 | 7.07310826e-010 |
| C2 | -2.00157185e-014 |
| C3 | -9.33825109e-020 |
| C4 | 1.27125854e-024 |
| C5 | 1.94008709e-027 |
| C6 | -6.11989858e-032 |
| C7 | 2.92367322e-036 |
| C8 | 0.00000000e+000 |
| C9 | 0.00000000e+000 |

Asphäre der Linse L624

| K | 0.0000 |
|---|---|
| C1 | 3.02835805e-010 |
| C2 | -3.90484062e-014 |
| C3 | -3.22339189e-019 |
| C4 | 1.64516979e-022 |
| C5 | -8.51268614e-027 |
| C6 | 2.09276792e-031 |
| C7 | -4.74605669e-036 |
| C8 | 0.00000000e+000 |
| C9 | 0.00000000e+000 |

Asphäre der Linse L625

| | |
|---|---|
| K | 0.0000 |
| C1 | -3.99248993e-010 |
| C2 | 5.79276562e-014 |
| C3 | 3.53241478e-018 |
| C4 | -4.57872308e-023 |
| C5 | -6.29695208e-027 |
| C6 | 1.57844931e-031 |
| C7 | -2.19266130e-036 |
| C8 | 0.00000000e+000 |
| C9 | 0.00000000e+000 |

Asphäre der Linse L628

| | |
|---|---|
| K | 0.0000 |
| C1 | 4.40737732e-008 |
| C2 | 1.52385268e-012 |
| C3 | -5.44510329e-016 |
| C4 | 6.32549789e-020 |
| C5 | -4.58358203e-024 |
| C6. | 1.92230388e-028 |
| C7 | -3.11311258e-033 |
| C8 | 0.00000000e+000 |
| C9 | 0.00000000e+000 |

**TABELLE 7** M1630a

| LINSEN | RADIEN | DICKEN | GLÄSER | BRECHZAHL BEI 193.304nm | 1/2 FREIER DURCHMESSER |
|---|---|---|---|---|---|
| 0 | unendlich | 32.989007360 | L710 | 09999200 | 56.080 |
| | unendlich | 2.050119724 | L710 | 09999200 | 63.700 |
| L701 | 1292.577885893AS | 17.083079028 | SIO2 | 15602895 | 64.846 |
| | -320.912994055 | 6.356545111 | HE | 09997200 | 65.549 |
| L702 | -222.076099367 | 9.996105426 | SIO2 | 15602895 | 65.651 |
| | -173.186007383 | 14.918724377 | HE | 09997200 | 66.515 |
| L703 | -465.289541055 | 12.849128877 | SIO2 | 15602895 | 65.892 |
| | -190.575077708 | 24.825544140 | HE | 09997200 | 66.089 |
| L704 | -88.003869940 | 9.278158320 | SIO2 | 1.56028895 | 64.773 |
| | -80.342454766AS | 3.110021891 | HE | 0.99971200 | 66.529 |
| L705 | -104.692897461AS | 6.185438880 | SIO2 | 15602895 | 63.593 |
| | 687.929853355 | 8.052826671 | HE | 09997200 | 65.986 |
| L706 | -4211.039282601 | 6.185438880 | SIO2 | 15602895 | 66.833 |
| | 191.063416206 | 42.178241931 | HE | 09997200 | 69.389 |
| L707 | -115.620656932 | 6.185438880 | SIO2 | 15602895 | 71.596 |
| | 10919.608812170AS | 23.544585745 | HE | 09997200 | 91.649 |
| L708 | -462.245785462 | 36.857934334 | SIO2 | 15602895 | 105.419 |
| | -166.710127403 | 0.922637637 | HE | 09997200 | 110.921 |
| L709 | -2362.175430424AS | 61.803635845 | SIO2 | 15602895 | 140.744 |
| | -209.701792909 | 1.020714627 | HE | 09997200 | 144.651 |
| L710 | -389.602200799 | 25.772662000 | SIO2 | 15602895 | 151.693 |
| | -307.008965979 | 0.721634536 | HE | 09997200 | 156.014 |

Tabelle fortgesetzt

| LINSEN | RADIEN | DICKEN | GLÄSER | BRECHZAHL BEI 193.304nm | 1/2 FREIER DURCHMESSER |
|---|---|---|---|---|---|
| L711 | 629.229001456 | 46.511934207 | SIO2 | 1.5608995 | 167.044 |
| | -859.369679090 | 24.151857437 | HE | 0.9997.1200 | 167.077 |
| L712 | -877.205712077 | 30.754166393 | SIO2 | 1.5608995 | 164.429 |
| | -357.572652646 | 4.953800031 | HE | 0.9997.1200 | 164.440 |
| L713 | 168.111512940 | 68.382989629 | SIO2 | 1.5608995 | 129.450 |
| | unendlich | 0.000000000 | HE | 0.9997.1200 | 125.021 |
| L714 | unendlich | 8.247251840 | SIO2 | 1.5608995 | 125.021 |
| | 149.672876100AS | 23.428435757 | HE | 0.9997.1200 | 98.369 |
| L715 | 167.316121704 | 0.000000000 | SIO2 | 1.5608995 | 92.117 |
| | 167.316121704 | 46.368104843 | HE | 0.9997.1200 | 92.117 |
| L716 | -276.014955570 | 6.185438880 | SIO2 | 1.5608995 | 90.583 |
| | 122.032488640AS | 68.057116286 | HE | 0.9997.1200 | 84.260 |
| L717 | -131.026926440 | 6.185438880 | SIO2 | 1.5608995 | 85.665 |
| | 1443.442379280 | 24.936997937 | HE | 0.9997.1200 | 105.177 |
| L718 | -570.720178737 | 31.985422479 | SIO2 | 1.5608995 | 114.725 |
| | -251.966065824 | 0.742435413 | HE | 0.9997.1200 | 122.318 |
| L719 | -792.022948046 | 31.395737994 | SIO2 | 1.5608995 | 136.726 |
| | -284.699402375 | 0.732480789 | HE | 0.9997.1200 | 139.887 |
| L720 | -1399.992577177 | 28.528105133 | SIO2 | 1.5608995 | 152.678 |
| | -405.074653331 | 0.721634536 | HE | 0.9997.1200 | 154.617 |
| L721 | 969.181518515 | 52.876050649 | SIO2 | 1.5608995 | 166.429 |
| | -498.113891823 | 15.463597200 | HE | 0.9997.1200 | 167.335 |
| | unendlich | -10.309064800 | HE | 0.9997.1200 | 163.661 |
| L722 | 369.912797108AS | 22.457291722 | SIO2 | 1.5608995 | 164.702 |
| | 546.240476474 | 0.759815621 | HE | 0.9997.1200 | 163.421 |
| L723 | 435.783427872 | 59.712335014 | SIO2 | 1.5608995 | 163.043 |
| | -757.138748183 | 38.604277894 | HE | 0.9997.1200 | 161.173 |
| L724 | -268.662949002 | 15.463597200 | SIO2 | 1.56028895 | 159.696 |
| | -299.983850179AS | 20.130367113 | HE | 0.9997.1200 | 160.684 |
| L725 | -232.880394011AS | 19.892839003 | SIO2 | 1.5608995 | 159.263 |
| | -238.077482924 | 0.721634536 | HE | 0.9997.1200 | 162.099 |
| L726 | 238.488298578 | 23.631362631 | SIO2 | 1.5608995 | 127.621 |
| | 378.766536032 | 0.721634536 | HE | 0.9997.1200 | 124.291 |
| L727 | 136.105324171 | 29.608483074 | SIO2 | 1.56028895 | 108.001 |
| | 205.107042559 | 0.785819222 | HE | 0.9997.1200 | 104.429 |
| L728 | 143.303538802 | 37.757018324 | SIO2 | 1.5608995 | 96.584 |
| | 1247.979376087AS | 8.449273703 | HE | 0.9997.1200 | 91.946 |
| L729 | unendlich | 26.717587971 | CaF2 | 1.5014363 | 85.145 |
| | unendlich | 5.154532400 | L710 | 0.9998200 | 65.152 |
| L730 | unendlich | 25.772662000 | CaF2 | 1.5014363 | 54.537 |
| | unendlich | 10.309064800 | L710 | 0.9998200 | 35.251 |
| L731 | unendlich | | | 0.0000000 | 14.020 |

L710 = Luft bei 710 Torr

ASPHAERISCHE KONSTANTEN

Asphäre der Linse L701

K   0.0000
C1   6.70377274e-008
C2   6.84099199e-013
C3   1.05733405e-016
C4   3.37349453e-020
C5   -7.15705547e-024
C6   5.09786203e-028
C7   -6.46970874e-033
C8   0.00000000e+000
C9   O.OOOOOOOOe+000

Asphäre der Linse L704

K   -1.3610
C1   -2.19369509e-007
C2   7.67800088e-012
C3   -6.07796875e-015
C4   7.90645856e-019
C5   -9.11112500e-023
C6   5.68885354e-027
C7   -4.26463481e-031
C8   0.00000000e+000
C9   0.00000000e+000

Asphäre der Linse L705

K   -1.2060
C1   8.09444891e-008
C2   4.80824558e-012
C3   -4.20373603e-015
C4   5.60648644e-019
C5   -4.51520330e-023
C6   1.54505188e-027
C7   5.00741161e-032
C8   0.00000000e+000
C9   0.00000000e+000

Asphäre der Linse L707

K   0.0000
C1   7.63455153e-008
C2   -8.56292259e-012
C3   3.01669569e-016
C4   9.61573017e-021
C5   -2.67588216e-024
C6   2.05728418e-028
C7   -6.45595651e-033
C8   0.00000000e+000
C9   0.00000000e+000

Asphäre der Linse L709

| | |
|---|---|
| K | 0.0000 |
| C1 | 3.23214391e-009 |
| C2 | -1.67326019e-013 |
| C3 | -4.26702152e-019 |
| C4 | -5.66712884e-023 |
| C5 | -1.24256704e-028 |
| C6 | 1.64124726e-031 |
| C7 | -4.41379927e-036 |
| C8 | 0.00000000e+000 |
| C9 | 0.00000000e+000 |

Asphäre der Linse L714

| | |
|---|---|
| K | 0.0000 |
| C1 | -1.63753926e-009 |
| C2 | 2.54837542e-013 |
| C3 | 8.79430055e-018 |
| C4 | 9.19127213e-022 |
| C5 | -7.01950932e-026 |
| C6 | 1.17918461e-029 |
| C7 | -8.74308763e-034 |
| C8 | 0.00000000e+000 |
| C9 | 0.00000000e+000 |

Asphäre der Linse L716

| | |
|---|---|
| K | 0.0000 |
| C1 | -1.54725313e-008 |
| C2 | -4.26275476e-012 |
| C3 | -1.01484275e-016 |
| C4 | 8.37843426e-022 |
| C5 | -1.29202167e-024 |
| C6 | 1.71820044e-028 |
| C7 | -1.05335330e-032 |
| C8 | 0.00000000e+000 |
| C9 | 0.00000000e+000 |

Asphäre der Linse L722

| | |
|---|---|
| K | -0.0331 |
| C1 | 2.56540619e-011 |
| C2 | -6.98183157e-015 |
| C3 | 7.92101859e-021 |
| C4 | -5.85807569e-025 |
| C5 | 2.42288782e-028 |
| C6 | -5.79467899e-033 |
| C7 | 1.63689132e-037 |
| C8 | 0.00000000e+000 |
| C9 | 0.00000000e+000 |

Asphäre der Linse L724

| | |
|---|---|
| K | 0.0000 |
| C1 | 8.90820785e-011 |
| C2 | -1.06772804e-014 |
| C3 | -1.68281363e-019 |
| C4 | 3.04828021e-023 |
| C5 | -1.01185483e-027 |
| C6 | 1.61617917e-032 |
| C7 | -2.40582729e-037 |
| C8 | 0.00000000e+000 |
| C9 | 0.00000000e+000 |

Asphäre der Linse L725

| | |
|---|---|
| K | 0.0000 |
| C1 | -1.97757640e-010 |
| C2 | 2.05110497e-014 |
| C3 | 8.96864099e-019 |
| C4 | -9.85543257e-024 |
| C5 | -7.12993590e-028 |
| C6 | 1.30146671e-032 |
| C7 | -1.36102788e-037 |
| C8 | 0.00000000e+000 |
| C9 | 0.00000000e+000 |

Asphäre der Linse L728

| | |
|---|---|
| K | 0.0000 |
| C1 | 2.55097376e-008 |
| C2 | 5.47467657e-013 |
| C3 | -1.43568713e-016 |
| C4 | 1.17677649e-020 |
| C5 | -5.95320448e-025 |
| C6 | 1.71763367e-029 |
| C7 | -1.94556007e-034 |
| C8 | 0.00000000e+000 |
| C9 | 0.00000000e+000 |

## TABELLE 8 L61

| LINSEN | RADIEN | DICKEN | GLÄSER | BRECHZAHL BEI 157.13 nm | 1/2 FREIER DURCHMESSER |
|---|---|---|---|---|---|
| 0 | unendlich | 34.000000000 | | 1.00000000 | 82.150 |
| | unendlich | 0.100000000 | | 1.00000000 | 87.654 |
| L801 | 276.724757380 | 40.000000000 | CaF2 | 1.55970990 | 90.112 |
| | 1413.944109416AS | 95.000000000 | | 1.00000000 | 89.442 |
| SP1 | unendlich | 11.000000000 | | 1.00000000 | 90.034 |
| | unendlich | 433.237005445 | | 1.00000000 | 90.104 |
| L802 | -195.924336384 | 17.295305525 | CaF2 | 1.55970990 | 92.746 |
| | -467.658808527 | 40.841112468 | | 1.00000000 | 98.732 |
| L803 | -241.385736441 | 15.977235467 | CaF2 | 1.55970990 | 105.512 |

Tabelle fortgesetzt

| LINSEN | RADIEN | DICKEN | GLÄSER | BRECHZAHL BEI 157.13 nm | 1/2 FREIER DURCHMESSER |
|---|---|---|---|---|---|
|  | -857.211727400AS | 21.649331094 |  | 1.00000000 | 118.786 |
| SP2 | unendlich | 0.000010000 |  | 1.00000000 | 139.325 |
|  | 253.074839896 | 21.649331094 |  | 1.00000000 | 119.350 |
| L803' | 857.211727400AS | 15.977235467 | CaF2 | 1.55970990 | 118.986 |
|  | 241.385736441 | 40.841112468 |  | 1.00000000 | 108.546 |
| L802' | 467.658808527 | 17.295305525 | CaF2 | 1.55970990 | 102.615 |
|  | 195.924336384 | 419.981357165 |  | 1.00000000 | 95.689 |
| SP3 | unendlich | 6.255658280 |  | 1.00000000 | 76.370 |
|  | unendlich | 42.609155219 |  | 1.00000000 | 76.064 |
| Z1 | unendlich | 67.449547115 |  | 1.00000000 | 73.981 |
| L8.04 | 432.544479547 | 37.784311058 | CaF2 | 1.55970990 | 90.274 |
|  | -522.188532471 | 113.756133662 |  | 1.00000000 | 92.507 |
| L805 | -263.167605725 | 33.768525968 | CaF2 | 1.55970990 | 100.053 |
|  | -291.940616829AS | 14.536591424 |  | 1.00000000 | 106.516 |
| L806 | 589.642961222AS | 20.449887046 | CaF2 | 1.55970990 | 110.482 |
|  | -5539.698828792 | 443.944079795 |  | 1.00000000 | 110.523 |
| L807 | 221.780582003 | 9.000000000 | CaF2 | 1.55970990 | 108.311 |
|  | 153.071443064 | 22.790060084 |  | 1.00000000 | 104.062 |
| L808 | 309.446967518 | 38.542735318 | CaF2 | 1.55970990 | 104.062 |
|  | -2660.227900099 | 0.100022286 |  | 1.00000000 | 104.098 |
| L809 | 23655.354584194 | 12.899131182 | CaF2 | 1.55970990 | 104.054 |
|  | -1473.189213176 | 9.318886362 |  | 1.00000000 | 103.931 |
| L810 | -652.136459374 | 16.359499814 | CaF2 | 1.55970990 | 103.644 |
|  | -446.489459129 | 0.100000000 |  | 1.00000000 | 103.877 |
| L811 | 174.593507050 | 25.900313780 | CaF2 | 1.55970990 | 99.267 |
|  | 392.239615259AS | 14.064505431 |  | 1.00000000 | 96.61.0 |
|  | unendlich | 2.045119392 |  | 1.00000000 | 96.552 |
| L812 | 7997.306838492 | 16.759051656 | CaF2 | 1.55970990 | 96.383 |
|  | 318.210831711 | 8.891640764 |  | 1.00000000 | 94.998 |
| L813 | 428.724465129 | 41.295806263 | CaF2 | 1.55970990 | 95.548 |
|  | 3290.097860119AS | 7.377912006 |  | 1.00000000 | 95.040 |
| L814 | 721.012739719 | 33.927118706 | CaF2 | 1.55970990 | 95.443 |
|  | -272.650872353 | 6.871397517 |  | 1.00000000 | 95.207 |
| L815 | 131.257556743 | 38.826450065 | CaF2 | 1.55970990 | 81.345 |
|  | 632.112566477AS | 4.409527396 |  | 1.00000000 | 74.847 |
| L816 | 342.127616157AS | 37.346293509 | CaF2 | 1.55970990 | 70.394 |
|  | 449.261078744 | 4.859754445 |  | 1.00000000 | 54.895 |
| L817 | 144.034814702 | 34.792179308 | CaF2 | 1.55970990 | 48.040 |
|  | -751.263321098AS | 11.999872684 |  | 1.00000000 | 33.475 |
| 0' | unendlich | 0.000127776 |  | 1.00000000 | 16.430 |

ASPHAERISCHE KONSTANTEN

Asphäre der Linse L801

K    0.0000
C1    4.90231706e-009
C2    3.08634889e-014

Tabelle fortgesetzt

Asphäre der Linse L801

| | |
|---|---|
| C3 | -9.53005325e-019 |
| C4 | -6.06316417e-024 |
| C5 | 6.11462814e-028 |
| C6 | -8.64346302e-032 |
| C7 | 0.00000000e+000 |
| C8 | 0.00000000e+000 |
| C9 | 0.00000000e+000 |

Asphäre der Linse L803

| | |
|---|---|
| K | 0.0000 |
| C1 | -5.33460884e-009 |
| C2 | 9.73867225e-014 |
| C3 | -3.28422058e-018 |
| C4 | 1.50550421e-022 |
| C5 | 0.00000000e+000 |
| C6 | 0.00000000e+000 |
| C7 | 0.00000000e+000 |
| C8 | 0.00000000e+000 |
| C9 | 0.00000000e+000 |

Asphäre der Linse L803

| | |
|---|---|
| K | 0.0000 |
| C1 | 5.33460884e-009 |
| C2 | -9.73867225e-014 |
| C3 | 3.28422058e-018 |
| C4 | -1.50550421e-022 |
| C5 | 0.00000000e+000 |
| C6 | 0.00000000e+000 |
| C7 | 0.00000000e+000 |
| C8 | 0.00000000e+000 |
| C9 | 0.00000000e+000 |

Asphäre der Linse L805

| | |
|---|---|
| K | 0.0000 |
| C1 | 2.42569449e-009 |
| C2 | 3.96137865e-014 |
| C3 | -2.47855149e-018 |
| C4 | 7.95092779e-023 |
| C5 | 0.00000000e+000 |
| C6 | 0.00000000e+000 |
| C7 | 0.00000000e+000 |
| C8 | 0.00000000e+000 |
| C9 | 0.00000000e+000 |

Asphäre der Linse L806

| | |
|---|---|
| K | 0.0000 |
| C1 | -6.74111232e-009 |
| C2 | -2.57289693e-014 |
| C3 | -2.81309020e-018 |
| C4 | 6.70057831e-023 |
| C5 | 5.06272344e-028 |
| C6 | -4.81282974e-032 |
| C7 | 0.00000000e+000 |
| C8 | 0.00000000e+000 |
| C9 | 0.00000000e+000 |

Asphäre der Linse L811

| | |
|---|---|
| K | 0.0000 |
| C1 | 2.28889624e-008 |
| C2 | -1.88390559e-014 |
| C3 | 2.86010656e-017 |
| C4 | -3.18575336e-021 |
| C5 | 1.45886017e-025 |
| C6 | -1.08492931e-029 |
| C7 | 0.00000000e+000 |
| C8 | 0.00000000e+000 |
| C9 | 0.00000000e+000 |

Asphäre der Linse L813

| | |
|---|---|
| K | 0.0000 |
| C1 | 3.40212872e-008 |
| C2 | -1.08008877e-012 |
| C3 | 4.33814531e-017 |
| C4 | -7.40125614e-021 |
| C5 | 5.66856812e-025 |
| C6 | 0.00000000e+000 |
| C7 | 0.00000000e+000 |
| C8 | 0.00000000e+000 |
| C9 | 0.00000000e+000 |

Asphäre der Linse L815

| | |
|---|---|
| K | 0.0000 |
| C1 | -3.15395039e-008 |
| C2 | 4.30010133e-012 |
| C3 | 3.11663337e-016 |
| C4 | -3.64089769e-020 |
| C5 | 1.06073268e-024 |
| C6 | 0.00000000e+000 |
| C7 | 0.00000000e+000 |
| C8 | 0.00000000e+000 |
| C9 | 0.00000000e+000 |

Asphäre der Linse L816

| | |
|---|---|
| K | 0.0000 |
| C1 | -2.16579623e-008 |
| C2 | -6.67182801e-013 |
| C3 | 4.46519932e-016 |
| C4 | -3.71571535e-020 |
| C5 | 0.00000000e+000 |
| C6 | 0.0000000e+000 |
| C7 | 0.00000000e+000 |
| C8 | 0.00000000e+000 |
| C9 | 0.00000000e+000 |

Asphäre der Linse L817

| | |
|---|---|
| K | 0.0000 |
| C1 | 2.15121397e-008 |
| C2 | -1.65301726e-011 |
| C3 | -5.03883747e-015 |
| C4 | 1.03441815e-017 |
| C5 | -6.29122773e-021 |
| C6 | 1.44097714e-024 |
| C7 | 0.00000000e+000 |
| C8 | 0.00000000e+000 |
| C9 | O.OOOOOOOOe+000 |

**Patentansprüche**

1. Projektionsobjektiv mit einer Objektebene 0 und mit einer Bildebene 0' mit einer Mehrzahl an Linsen, wobei mindestens zwei benachbart zueinander angeordnete Linsenoberflächen asphärisch sind, die im folgenden als Doppelasphäre bezeichnet werden, die Doppelasphäre in einem Abstand von mindestens dem maximalen Linsendurchmesser (D2) des Objektivs von der Bildebene 0' beabstandet angeordnet ist **dadurch gekennzeichnet, dass** der Abstand (23) zwischen den asphärischen Linsenoberflächen der Doppelasphäre (21) kleiner als der halbe Linsendurchmesser des gemittelten Linsendurchmessers der Doppelasphäre (21) ist,
und dass
mittels der Doppelasphären (21) eine numerische Apertur von mindestens 0,8 bereit gestellt wird.

2. Projektionsobjektiv nach Anspruch 1,
**dadurch gekennzeichnet, dass**
es refraktiv ist und mindestens fünf Linsengruppen (G1 - G5) enthält.

3. Projektionsobjektiv nach Anspruch 2
**dadurch gekennzeichnet, dass**
zwei der Linsengruppen negative Brechkraft haben und mindestens eine dieser Linsengruppen negativer Brechkraft nur zwei Linsen negativer Brechkraft umfasst.

4. Projektionsobjektiv nach Anspruch 3,
**dadurch gekennzeichnet, dass**
auch die zweite Linsengruppe negativer Brechkraft maximal zwei Linsen negativer Brechkraft aufweist.

5. Projektionsobjektiv nach Anspruch 4,
**dadurch gekennzeichnet, dass**
in der zweiten Taille eine asphärische Linsenoberfläche angeordnet ist.

37

**6.** Projektionsobjektiv nach Anspruch 4 oder 5,
**dadurch gekennzeichnet, dass**
in einer Linsengruppe (G5) positiver Brechkraft, in der eine Blende (AP) angeordnet ist, mindestens eine Linse (L720, L722, L723) mit einer asphärischen Linsenoberfläche vorgesehen ist.

**7.** Projektionsobjektiv mindestens nach Anspruch 2,
**dadurch gekennzeichnet, dass**
die asphärische Linsenoberflächen (AS1 und AS2, AS3 und AS4) auf verschiedenen Linsen (L) angeordnet sind.

**8.** Projektionsobjektiv nach Anspruch 2,
**dadurch gekennzeichnet, dass**
alle asphärischen Linsen (L104, L105, L107, L111, L203, L204, L206, L211) vor der zweiten Taille (G4) angeordnet sind.

**9.** Projektionsobjektiv mindestens nach Anspruch 2,
**dadurch gekennzeichnet, dass**
zwischen den asphärischen Linsenoberflächen der Doppelasphäre (AS1 - AS4) ein Luftspalt (23) gemessen auf der optischen Achse (7) von maximal 20% ihres gemittelten Radiusses vorgesehen ist.

**10.** Projektionsobjektiv mindestens nach Anspruch 1, 2 oder 7,
**dadurch gekennzeichnet, dass**
die benachbart angeordneten asphärischen Linsenoberflächen (AS1-AS4) in einem äquidistanten Abstand voneinander angeordnet sind.

**11.** Refraktives Projektionsobjektiv nach mindestens einem der vorangegangenen Ansprüche 2 - 10,
**dadurch gekennzeichnet, dass**
in den ersten drei Linsengruppen (G1 bis G3) mindestens eine Doppelasphäre (21) angeordnet ist.

**12.** Projektionsobjektiv mindestens nach Anspruch 1, 2 oder 7,
**dadurch gekennzeichnet, dass**
sich die Radien der am besten passenden sphärischen Linsenoberflächen einer Doppelasphäre, die der jeweiligen asphärischen Linsenoberfläche (AS1 bis AS4) zugeordnet ist, um weniger als 30 % voneinander unterscheiden, wobei von dem vom Betrag größeren Radius ausgegangen wird.

**13.** Projektionsobjektiv mindestens nach Anspruch 1,2 oder 7,
**dadurch gekennzeichnet, dass** sich die Scheitelradien der am besten passenden sphärischen Linsenoberflächen einer Doppelasphäre, die der jeweiligen asphärischen Linsenoberfläche (AS1 bis AS4) zugeordnet ist, um weniger als 30 % voneinander unterscheiden, wobei von dem vom Betrag größeren Radius ausgegangen wird.

**14.** Projektionsobjektiv nach mindestens einem der vorangegangenen Ansprüche,
**dadurch gekennzeichnet, dass**
sich die Durchmesser der ersten 13 Linsenoberflächen nahezu nicht, vorzugsweise um weniger als 10 %, unterscheiden.

**15.** Projektionsobjektiv mindestens nach Anspruch 2 oder 7,
**dadurch gekennzeichnet, dass**
die ersten 13 Linsenoberflächen einen Durchmesser (D1) aufweisen, der kleiner als 40 % des maximalen Durchmessers (D2) von Linsen des Objektives (5) ist.

**16.** Projektionsobjektiv nach mindestens einem der vorangegangenen Ansprüche,
**dadurch gekennzeichnet dass**,
mittels der Doppelasphären (21) eine numerische Apertur von mindestens 0,9 bereit gestellt wird.

**17.** Projektionsobjektiv nach mindestens einem der vorangegangenen Ansprüche,
**dadurch gekennzeichnet, dass**
durch zwei Linsenoberflächen ein mit Fluid beaufschlagbarer Zwischenraum gebildet wird.

**18.** Projektionsobjektiv mindestens nach Anspruch 1 oder 2,

**dadurch gekennzeichnet, dass**
mindestens 40 % der Linsen, vorzugsweise 60% der Linsen, sphärisch sind.

19. Projektionsobjektiv nach Anspruch 2,
**dadurch gekennzeichnet, dass**
mindestens 60 % der Linsen sphärisch sind.

20. Projektionsobjektiv nach mindestens einem der Ansprüche 1 bis 19,
**dadurch gekennzeichnet, dass**
das Projektionsobjektiv in einer Projektionsbelichtungsanlage der Mikrolithographie enthalten ist.

21. Verfahren zur Herstellung mikrostrukturierter Bauteile bei dem ein mit einer lichtempfindlichen Schicht versehenes Substrat (15) mittels einer Maske (9) und einer Projektionsbelichtungsanlage (1) mit einer Linsenanordnung (19) nach mindestens einem der Ansprüche 1 bis 19 durch ultraviolettes Laserlicht belichtet wird und gegebenenfalls nach Entwickeln der lichtempfindlichen Schicht entsprechend einem auf der Maske enthaltenen Muster strukturiert wird.

**Claims**

1. Projection objective having an object plane 0 and having an image plane 0' with a plurality of lenses, at least two lens surfaces arranged adjacent to one another being aspheric and denoted below as a double asphere, the double asphere being arranged spaced apart from the image plane 0' at a distance of at least the maximum lens diameter (D2) of the objective, **characterized in that** the distance (23) between the aspheric lens surfaces of the double asphere (21) is smaller than half the lens diameter of the averaged lens diameter of the double asphere (21), and **in that** a numerical aperture of at least 0.8 is provided by means of the double aspheres (21).

2. Projection objective according to Claim 1, **characterized in that** it is refractive and includes at least five lens groups (G1-G5).

3. Projection objective according to Claim 2, **characterized in that** two of the lens groups have negative refractive power, and at least one of these lens groups of negative refractive power comprises only two lenses of negative refractive power.

4. Projection objective according to Claim 3, **characterized in that** the second lens group of negative refractive power also has at most two lenses of negative refractive power.

5. Projection objective according to Claim 4, **characterized in that** an aspheric lens surface is arranged in the second waist.

6. Projection objective according to Claim 4 or 5, **characterized in that** at least one lens (L720, L722, L723) with an aspheric lens surface is provided in a lens group (G5) of positive refractive power in which a diaphragm (AP) is arranged.

7. Projection objective at least according to Claim 2, **characterized in that** the aspheric lens surfaces (AS1 and AS2, AS3 and AS4) are arranged on different lenses (L).

8. Projection Objective according to Claim 2, **characterized in that** all the aspheric lenses (L104, L105, L107, L111, L203, L204, L206, L211) are arranged upstream of the second waist (G4).

9. Projection objective at least according to Claim 2, **characterized in that**, measured on the optical axis (7), an air gap (23) of at most 20% of the mean radius of the double asphere (AS1-AS4) is provided between the aspheric lens surfaces of said double asphere.

10. Projection objective at least according to Claim 1, 2 or 7, **characterized in that** the adjacently arranged aspheric lens surfaces (AS1-AS4) are arranged at an equidistant spacing from one another.

11. Refractive projection objective according to at least one of the preceding claims 2-10, **characterized in that** at least one double asphere (21) is arranged in the first three lens groups (G1 to G3).

12. Projection objective at least according to Claim 1, 2 or 7, **characterized in that** the radii of the most suitable spherical lens surfaces of a double asphere which is assigned to the respective aspherical lens surface (AS1 to AS4) differ from one another by less than 30%, the starting point being the radius of larger absolute value.

13. Projection objective at least according to Claim 1, 2 or 7, **characterized in that** the vertex radii of the most suitable spherical lens surfaces of a double asphere which is assigned to the respective aspheric lens surface (AS1 to AS4) differ from one another by less than 30%, the starting point being the radius of larger absolute magnitude.

14. Projection objective according to at least one of the preceding claims, **characterized in that** the diameters of the first 13 lens surfaces virtually do not differ from one another, preferably doing so by less than 10%.

15. Projection objective at least according to Claim 2 or 7, **characterized in that** the first 13 lens surfaces have a diameter (D1) which is smaller than 40% of the maximum diameter (D2) of lenses of the objective (5).

16. Projection objective according to at least one of the preceding claims, **characterized in that** a numerical aperture of at least 0.9 is provided by means of the double aspheres (21).

17. Projection objective according to at least one of the preceding claims, **characterized in that** two lens surfaces form an interspace to which fluid can be applied.

18. Projection objective at least according to Claim 1 or 2, **characterized in that** at least 40% of the lenses, preferably 60% of the lenses, are spherical.

19. Projection objective according to Claim 2, **characterized in that** at least 60% of the lenses are spherical.

20. Projection objective according to at least one of Claims 1 to 19, **characterized in that** the projection objective is included in a microlithography projection exposure machine.

21. Method for producing microstructured components, in the case of which a substrate (15) provided with a photosensitive layer is exposed to ultraviolet laser light by means of a mask (9) and a projection exposure machine (1) having a lens arrangement (19) according to at least one of Claims 1 to 19, and, if appropriate, after development of the photosensitive layer, patterned in accordance with a pattern contained on the mask.

**Revendications**

1. Objectif de projection qui présente un plan d'objet 0 et un plan d'image 0' ainsi que plusieurs lentilles, dans lequel au moins deux surfaces de lentilles agencées au voisinage l'une de l'autre sont non sphériques et forment ce qui, à la suite, est appelé double asphère, dans lequel la distance entre cette dernière et le plan d'image 0' est au moins égal au diamètre maximal (D2) de lentille de l'objectif, **caractérisé en ce que** la distance (23) entre les surfaces asphériques de lentille de la double asphère (21) est inférieure à la moitié du diamètre moyen de lentille de la double asphère (21) et **en ce qu'**au moyen de la double asphère (21), on obtient une ouverture numérique d'au moins 0,8.

2. Objectif de projection selon la revendication 1, **caractérisé en ce qu'**il est réfringent et comprend au moins cinq groupes de lentilles (G1 - G5).

3. Objectif de projection selon la revendication 2, **caractérisé en ce que** deux des groupes de lentilles présentent un pouvoir réfringent négatif et au moins un de ces groupes de lentilles à pouvoir réfringent négatif ne présente que deux lentilles à pouvoir réfringent négatif.

4. Objectif de projection selon la revendication 3; **caractérisé en ce que** le deuxième groupe de lentilles à pouvoir réfringent négatif ne présente également au maximum que deux lentilles à pouvoir réfringent négatif.

5. Objectif de projection selon la revendication 4, **caractérisé en ce qu'**une surface asphérique de lentille est agencée dans le deuxième étranglement.

**6.** Objectif de projection selon les revendications 4 ou 5, **caractérisé en ce qu'**au moins une lentille (L720, L722, L723) qui présente une surface asphérique est prévue dans un groupe de lentilles (G5) à pouvoir réfringent positif dans lequel est agencé un filtre (AP).

**7.** Objectif de projection au moins selon la revendication 2, **caractérisé en ce que** les surfaces asphériques de lentille (AS1 et AS2, AS3 et AS4) sont agencées sur différentes lentilles (L).

**8.** Objectif de projection selon la revendication 2, **caractérisé en ce que** toutes les lentilles asphériques (L104, L105, L107, L111, L203, L204, L206, L211) sont agencées en amont du deuxième étranglement (G4).

**9.** Objectif de projection au moins selon la revendication 2, **caractérisé en ce qu'**un interstice d'air (23) qui, mesuré sur l'axe optique (7), représente au plus 20 % du rayon moyen de la double asphère (AS1 - AS4) est agencé entre les surfaces asphériques de lentille de cette dernière.

**10.** Objectif de projection au moins selon les revendications 1, 2 ou 7, **caractérisé en ce que** les surfaces asphériques de lentille (AS1 - AS4) agencées au voisinage les unes des autres le sont de façon équidistante.

**11.** Objectif réfringent de projection selon l'une au moins des revendications précédentes 2 à 10, **caractérisé en ce qu'**au moins une double asphère (21) est agencée dans les trois premiers groupes de lentilles (G1 à G3).

**12.** Objectif de projection au moins selon les revendications 1, 2 ou 7, **caractérisé en ce que** les surfaces sphériques les plus appropriées de lentille d'une double asphère, dont chacune est associée à une surface asphérique de lentille (AS1 à AS4), ont des rayons qui diffèrent les uns des autres de moins de 30 % du rayon le plus grand.

**13.** Objectif de projection au moins selon les revendications 1, 2 ou 7, **caractérisé en ce que** les surfaces sphériques les plus appropriées de lentille d'une double asphère, dont chacune est associée à une surface asphérique de lentille (AS1 à AS4), ont en leur sommet des rayons qui diffèrent les uns des autres de moins de 30 % du rayon le plus grand.

**14.** Objectif de projection selon l'une au moins des revendications précédentes, **caractérisé en ce que** les diamètres des 13 premières surfaces de lentilles ne diffèrent presque pas et de préférence de moins de 10 %.

**15.** Objectif de projection au moins selon les revendications 2 ou 7, **caractérisé en ce que** les 13 premières surfaces de lentilles ont un diamètre (D1) inférieur à 40 % du diamètre de lentille maximal (D2) de l'objectif (5).

**16.** Objectif de projection selon l'une au moins des revendications précédentes, **caractérisé en ce qu'**on obtient une ouverture numérique d'au moins 0,9 au moyen des doubles asphères (21).

**17.** Objectif de projection selon l'une au moins des revendications précédentes, **caractérisé en ce que** deux surfaces de lentilles forment un espace intermédiaire qui peut être alimenté en fluide.

**18.** Objectif de projection au moins selon les revendications 1 ou 2, **caractérisé en ce qu'**au moins 40 % et de préférence au moins 60 % des lentilles sont sphériques.

**19.** Objectif de projection selon la revendication 2, **caractérisé en ce qu'**au moins 60 % des lentilles sont sphériques.

**20.** Objectif de projection selon au moins l'une des revendications 1 à 19, **caractérisé en ce qu'**il fait partie d'une installation d'éclairage de projection pour microlithographie.

**21.** Procédé de fabrication de composants microstructurés, dans lequel on éclaire un support (15) muni d'une surface photosensible à travers un masque (9) et à la lumière laser ultraviolette avec une installation d'éclairage de projection (1) qui présente un agencement (19) de lentilles selon l'une au moins des revendications 1 à 19 et, éventuellement après avoir développé la couche photosensible, on structure ce support selon un motif présent sur le masque.

# FIG. 1

# FIG.2

EP 1 242 843 B1

FIG.3

## FIG. 4

L301 L302 L303 L304 L305 L306 L307 L308 L309 L310 L311 L312 L313 L314 L315 L316 L317 L318 L319 L320 L321 L322 L323 L324 L325 L326 L327 L328

O

D2
D1

21

As1 As2

23

19

As3 As4

23

O'

G1   G2   G3   G4   G5   G6

EP 1 242 843 B1

## FIG.5

EP 1 242 843 B1

## FIG.6

# FIG. 7

EP 1 242 843 B1

FIG.8

FIG.9

EP 1 242 843 B1